# EUROPEAN PATENT APPLICATION

(11) **EP 4 531 514 A1**
(43) Date of publication of application: **02.04.2025**
(21) Application number: 24178168.1
(22) Date of filing: 27.05.2024
(51) Int. Cl.: H10B 12/00

(54) **SEMICONDUCTOR DEVICE AND METHOD OF MANUFACTURING SEMICONDUCTOR DEVICE**

(30) Priority: 28.09.2023 CN 202311278827
(71) Applicant: SwaySure Technology Co., Ltd., Shenzhen (CN)
(72) Inventor: HSIEH, Ming-Hung, Shenzhen (CN)
(74) Representative: Studio Torta S.p.A.

(57) **Abstract**

A semiconductor device includes a substrate (10) and at least one functional layer (20). The functional layer (20) includes: a first signal line layer and a second signal line layer, stacked on the substrate (10) in a vertical direction, and the first signal line (203) and the second signal line (205) each extends in a first horizontal direction; and each has a body extension portion and a lead-out end, and for each of the first signal line (203) and the second signal line (205), the lead-out end is located at least one end of the body extension portion; an orthographic projection of the body extension portion of the first signal line (203) and the second signal line (205) on the substrate (10) are overlapping; and orthographic projections of the lead-out ends of the first signal line (203) and the second signal line (205) on the substrate (10) are non-overlapping. This solution facilitates the independent lead-out of signal lines from each layer.

## Description

### TECHNICAL FIELD

The present disclosure relates to the field of semiconductors, and more particularly, to a semiconductor device and a method of manufacturing a semiconductor device.

### BACKGROUND

With the development of the semiconductor industry, the market demand for memory density of the Dynamic Random Access Memory (DRAM) is getting higher and higher, but the existing 1T1C (T stands for transistor, C stands for capacitor) storage structure, i.e.: including a transistor and a capacitor, is difficult to realize three-dimensional stacking, and the memory density is affected by the critical dimensions when placed in planar, and the critical dimensions are limited by the development of photolithography, thus it is difficult to improve memory density. The 2T0C storage structure (i.e., including two transistors without the capacitor) can increase the memory density by continuously increasing the number of stacked layers without reducing the critical dimensions, but for the 2T0C storage structure, in the case of a plurality of layers of signal lines, and how to lead the signal lines out of each layer has become an urgent problem to be solved.

### SUMMARY

Accordingly, the present invention provides a semiconductor device and a method of manufacturing a semiconductor device, in accordance with claims which follow.

According to a first aspect of an embodiment of the present disclosure, the present disclosure provides a semiconductor device, comprising a substrate and at least one functional layer, the functional layer includes:
a first signal line layer and a second signal line layer, stacked on the substrate in a vertical direction, the first signal line layer includes a plurality of first signal lines spaced apart, and the second signal line layer includes a plurality of second signal lines spaced apart, the second signal line layer is located by a side of the first signal line layer away from the substrate and insulated from the second signal line layer by an insulation film layer, and the first signal line and the second signal line each extends in a first horizontal direction;
the first signal line and the second signal line each has a body extension portion and a lead-out end, and for each of the first signal line and the second signal line, the lead-out end is located at at least one end of the body extension portion in the first horizontal direction;
an orthographic projection of the body extension portion of the first signal line overlaps with an orthographic projection of the body extension portion of the second signal line on the substrate; and
orthographic projections of the lead-out ends of the first signal line and the second signal line on the substrate are non-overlapping.

According to a second aspect of an embodiment of the present disclosure, the present disclosure provides a method of manufacturing a semiconductor device, including:
providing a substrate; and
forming at least one functional layer on the substrate, wherein each the forming the functional layer includes:
   forming a first signal line layer and a first insulation film layer covering the first signal line layer on the substrate, the first signal line layer comprises a plurality of first signal lines spaced apart, each first signal line extends in a first horizontal direction; and
   forming a second signal line layer extending in the first horizontal direction by a side of the first insulation film layer away from the substrate, the second signal line layer comprises a plurality of second signal lines spaced apart;
   the first signal line and the second signal line each has a body extension portion and a lead-out end, and for each of the first signal line and the second signal line, the lead-out end is located at at least one end of the body extension portion in the first horizontal direction;
   an orthographic projection of the body extension portion of the first signal line overlaps with an orthographic projection of the body extension portion of the second signal line on the substrate; and
   orthographic projections of the lead-out ends of the first signal line and the second signal line on the substrate are non-overlapping.

The technical solution provided by embodiments of the present disclosure has at least the following advantages: the lead-out ends of the signal lines located in different layers and extending in the same direction are provided in a staggered non-overlapping manner, such that it is convenient for the signal lines of each layer to be led out independently without interfering with each other.

### BRIEF DESCRIPTION OF THE DRAWINGS

The accompanying drawings herein are incorporated into and form a part of the specification, and illustrate embodiments consistent with the present disclosure, and are used in conjunction with the specification to explain the principles of the present disclosure. Obviously, the accompanying drawings in the following description are only some of the embodiments of the present disclosure, and other accompanying drawings may be obtained from these drawings without creative labour for those skilled in the art.
FIG. 1 is a schematic perspective view of a semiconductor device according to an embodiment of the present disclosure.
FIG. 2 is a sectional view of the semiconductor device shown in FIG. 1 in the A-A direction.
FIG. 3 is a sectional view of the semiconductor device shown in FIG. 1 in the B-B direction.
FIG. 4 is a sectional view of a memory unit in the semiconductor device shown in FIG. 1 in the A-A direction.
FIG. 5 is a sectional view of the memory unit in the semiconductor device shown in FIG. 1 in the B-B direction.
FIGS. 6 to 43 are sectional views of the semiconductor device corresponding to each step that is completed in the method of manufacturing the semiconductor device in an embodiment of the present disclosure.

### DETAILED DESCRIPTION OF THE EMBODIMENTS

Embodiments will now be described more fully with reference to the accompanying drawings. However, the embodiments are capable of being implemented in a variety of forms and should not be construed as limitation to the examples set forth herein; rather, the provision of these embodiments allows the present disclosure to be more comprehensive and complete and conveys the idea of the embodiments in a comprehensive manner to those skilled in the art.

In addition, the described features, structures, or characteristics may be combined in one or more embodiments in any suitable manner. In the following description, many specific details are provided to give a full understanding of the embodiments of the present disclosure. However, those skilled in the art will realize that it is possible to practice the technical solutions of the present disclosure without one or more of the specific details, or that other methods, components, devices, steps, etc. may be adopted. In other cases, the well-known methods, devices, implementations, or operations are not shown or described in detail to avoid blurring aspects of the present disclosure.

The present disclosure is described in further detail below in connection with the accompanying drawings and specific embodiments. It should be noted herein that the technical features involved in the various embodiments of the present disclosure described below may be combined with each other as long as they do not constitute a conflict with each other. The embodiments described below by reference to the accompanying drawings are exemplary and are intended to be used to explain the present disclosure and are not to be construed as a limitation of the present disclosure.

The embodiments of the present disclosure provide a semiconductor device, which may be a DRAM, but is not limited thereto, and may be other types of semiconductor devices such as a ferroelectric random access memory (FeRAM), which will not be limited herein.

The structure of the semiconductor device of an embodiment of the present disclosure is described in detail below in conjunction with the accompanying drawings.

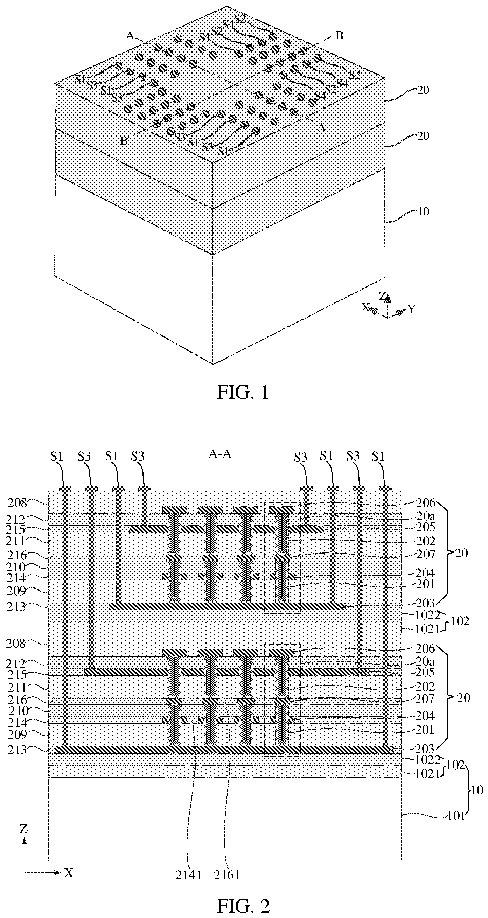

As shown in FIG. 1, the semiconductor device may include a substrate 10 and a functional layer 20, and the functional layer 20 may be formed on the substrate 10. In the present embodiment, two or more the functional layers 20 may be provided in the semiconductor device to increase the memory density of the semiconductor device, but is not limited thereto, or a single functional layer may also be provided.

When two or more the functional layers 20 are provided in the semiconductor device, the semiconductor device is understood to be a three-dimensional stacked semiconductor device.

It should be understood that the semiconductor device is not limited to including the functional layer 20, and may include structures such as a control circuit (not shown in the drawings) and a reading circuit in addition to the functional layer 20, which will not be described in detail herein.

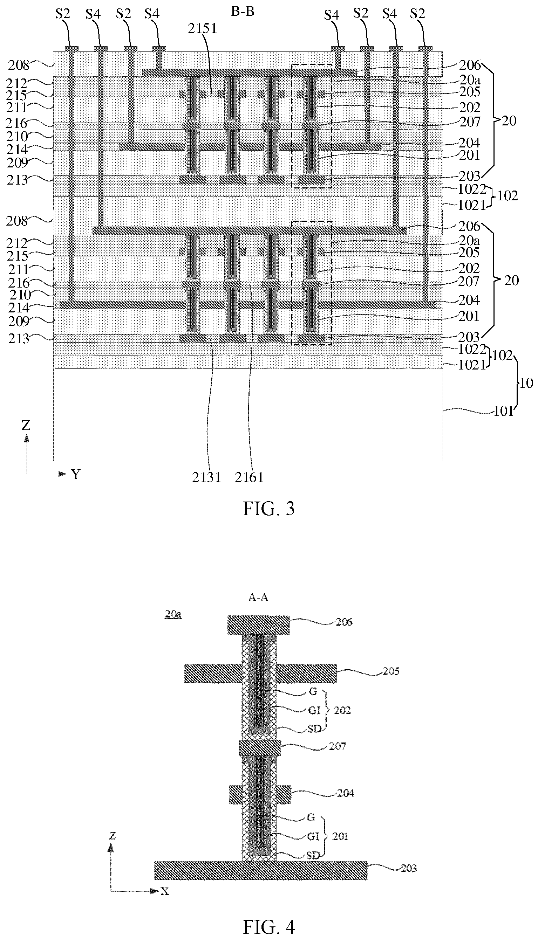

As shown in FIGS. 2 and 3, the substrate 10 may include a semiconductor substrate 101 and an insulating isolation layer 102 formed on the semiconductor substrate 101. In this embodiment, the insulating isolation layer 102 may be a stacked structure, which is formed by sequentially stacking two or more of film layers of different materials, but is not limited thereto, and the insulating isolation layer 102 may also be a single-layer structure.

By way of example, the material of the semiconductor substrate 101 may be such as silicon (Si) or germanium (Ge), but is not limited thereto, and may also be a crystalline inorganic compound semiconductor material such as silicon carbide (SiC), silicon germanium (Si Ge), etc. The material of the insulating isolation layer 102 may include one or more of such as silicon oxide (SiO₂), silicon nitride (SiN), silicon oxynitride (SiON), etc., or may also include other low-K materials.

As shown in FIGS. 2 and 3, the insulating isolation layer 102 may include a first film layer 1021 and a second film layer 1022 formed sequentially on the semiconductor substrate 101. The material of the first film layer 1021 may be a silicon oxide material, and the material of the second film layer 1022 may be a silicon nitride material, but is not limited thereto, and other insulation materials may be used for the first film layer 1021 and the second film layer 1022.

As shown in FIGS. 2 and 3, the functional layer 20 may include a first signal line layer and a second signal line layer stacked on the substrate 10 in a vertical direction Z. The first signal line layer includes a plurality of first signal lines 203 spaced apart. The second signal line layer includes a plurality of second signal lines 205 spaced apart. It is noted that the vertical direction Z may be a direction intersecting with the substrate 10, and furthermore, the vertical direction Z may be a direction perpendicular to or nearly perpendicular to the substrate 10.

The second signal line layer is located by a side of the first signal line layer away from the substrate 10 and is insulated from the first signal line layer by an insulation film layer. The first signal line 203 and the second signal line 205 extend in the first horizontal direction X. It should be noted that the first horizontal direction X may be a direction parallel to the substrate 10.

The first signal line 203 and the second signal line 205 each has a main body extension portion (not shown in the drawings) and a lead-out end (not shown in the drawings), and for each of the first signal line 203 and the second signal line 205, the lead-out end is located at at least one end of the body extension portion in the first horizontal direction X, and the lead-out end is configured to receive a level signal outputted from the control circuit or to output a level signal to the reading circuit through the lead-out structure.

There is an overlap in orthographic projections of the body extension portion of the first signal line 203 and the body extension portion of the second signal line 205 on the substrate 10; and there is no overlap in orthographic projections of the lead-out end of the first signal line 203 and the lead-out end of the second signal line 205 on the substrate 10, i.e., the lead-out ends of the signal lines that are located in different layers and extend in the same direction are staggered and not overlapped.

In this embodiment, the lead-out ends of the signal lines located in different layers and extend in the same direction are provided in a staggered non-overlapping manner, such that it is convenient for the signal lines of each layer to be led out independently without interfering with each other.

For each of the first signal line 203 and the second signal line 205, the lead-out end has a first surface close to the substrate 10 and a second surface away from the substrate. In the first signal line 203 and the second signal line 205, a direction of the first surface pointing to the second surface is the lead-out direction, but is not limited thereto, or a direction of the second surface pointing to the first surface is the lead-out direction, so that a lead-out structure connected to the first signal line 203 and a lead-out structure connected to the second signal line 205 can be led out on the same side, which is convenient for fabrication.

It should be noted that if the direction of the first surface pointing to the second surface is the lead-out direction, it means that the end of the lead-out structure connected to the corresponding lead-out end and away from the first surface is a tail end in the lead-out direction, which is used for connecting to the control circuit or the reading circuit, etc. If the direction of the second surface pointing to the first surface is the lead-out direction, it means that the end of the lead-out structure connected to the corresponding lead-out end and away from the second surface is a tail end in the lead-out direction, which is used for connecting to the control circuit or the reading circuit, etc. In addition, it should be noted that the end of the lead-out structure opposite to its tail end may be defined as a first end.

For example, the first end of the lead-out structure may be in contact with a first surface or a second surface of its corresponding lead-out end for electrical connection. Specifically, when the direction of the second surface pointing to the first surface is the lead-out direction, the lead-out structure is in contact with the first surface of its corresponding lead-out end, and when the direction of the first surface pointing to the second surface is the lead-out direction, the lead-out structure is in contact with the second surface of the its corresponding lead-out end. The surface in contact with the first end of the lead-out structure may be defined as the lead-out surface.

In this embodiment, for each of the first signal line 203 and the second signal line 205, the first surface of the lead-out end may be the lead-out surface, or for each of the first signal line 203 and the second signal line 205, the second surface of the lead-out end may be the lead-out surfaces, to be in contact with the first end of the lead-out structure for electrical connection, but not limited thereto, and grooves or through-holes may be opened in the lead-out ends of the first signal line 203 and the second signal line 205, so that the first ends of the lead-out structure may be embedded in the grooves or the through-holes to contact the lead-out ends of the first signal line 203 and the second signal line 205 to achieve an electrical connection therebetween.

In this embodiment, the extension lengths of the second signal line 205 and the first signal line 203 may be designed differently, i.e., the extension lengths of the signal lines located in different layers and extending in the same direction may be designed differently, so that a portion of the longer signal line in the plurality of signal lines located in different layers and extending in the same direction is uncovered by the shorter signal line, and it should be noted that the uncovered portion is the lead-out end, such that the plurality of signal lines located in different layers and extending in the same direction are arranged in a staircase manner, so as to facilitate the signal lines of each layer to be led out through different lead-out structures.

The stacking positions of the longer signal lines and the shorter signal lines extending in the same direction may be determined according to the lead-out direction. Exemplarily, for each of the first signal line 203 and the second signal line 205, when the direction of the second surface pointing to the first surface is the lead-out direction, the extension length of the first signal line 203 is less than the extension length of the second signal line 205 in the same functional layer 20; or for each of the first signal line 203 and the second signal line 205 when the direction of the first surface pointing to the second surface is the lead-out direction, the extension length of the second signal line 205 is less than the extension length of the first signal line 203 in the same functional layer 20.

Optionally, for each of the first signal line 203 and the second signal line 205, two opposite ends of the body extension portion in the first horizontal direction X are provided with lead-out ends, to facilitate connection with the control circuit.

In this embodiment, a plurality of the functional layers 20 can be provided, and are sequentially stacked on the substrate 10 in the vertical direction Z.

When a plurality of the functional layers 20 are provided, in two adjacent functional layers 20, for each of the first signal line 203 and the second signal line 205, the direction of the second surface pointing to the first surface is the lead-out direction, the extension length of the first signal line 203 in the functional layer 20 away from the substrate 10 is greater than the extension length of the second signal line 205 in the functional layer 20 close to the substrate 10; or for each of the first signal line 203 and the second signal line 205, when the direction of the first surface pointing to the second surface is the lead-out direction, the extension length of the first signal line 203 in the functional layer 20 away from the substrate 10 is less than the extension length of the second signal line 205 in the functional layer 20 close to the substrate 10.

The functional layer 20 may also include a third signal line layer, which includes a plurality of third signal lines 204 extending in the second horizontal direction Y The third signal line 204 has a body extension portion and a lead-out end, and the lead-out end of the third signal line 204 is located at at least one end of its body extension portion in the second horizontal direction Y The third signal line layer is stacked with the first signal line layer and the second signal line layer in the vertical direction Z, and adjacent signal line layers are insulated from each other by an insulation film layer. It is noted that the second horizontal direction Y is parallel to the substrate 10, and the second horizontal direction Y intersects with the first horizontal direction X. Further, the second horizontal direction Y and the first horizontal direction X may be perpendicular to each other.

The functional layer 20 further includes a fourth signal line layer, which includes a plurality of fourth signal lines 206 extending in the second horizontal direction Y, the fourth signal line 206 have a body extension portion and a lead-out end, the lead-out end of the fourth signal line 206 is located at at least one end of its body extension portion in the second horizontal direction Y The fourth signal line layer is stacked with the first signal line layer, the second signal line layer, and the third signal line layer in the vertical direction Z, and adjacent signal line layers are insulated from each other by an insulation film layer.

There is an overlap in orthographic projections of the body extension portion of the fourth signal line 206 and the body extension portion of the third signal line 204 on the substrate 10. There is no overlap in orthographic projections of the lead-out end of the fourth signal line 206 and the lead-out end of the third signal line 204 on the substrate 10, that is to say, the lead-out end of the fourth signal line 206 and the lead-out end of the third signal line 204 located in different layers and extending in the same direction are provided in a staggered non-overlapping manner.

For example, in the functional layer 20, the third signal line layer is formed between the first signal line layer and the second signal line layer. And in the functional layer 20, the fourth signal line layer is formed between the third signal line layer and the second signal line layer, or in the functional layer 20, the fourth signal line layer is formed by a side of the second signal line layer away from the third signal line layer.

It should be noted that for each of the third signal line 204 and the fourth signal line 206, the lead-out end has a first surface close to the substrate 10 and a second surface away from the substrate 10. For each of the third signal line 204 and the fourth signal line 206, the direction of the first surface pointing to the second surface is the lead-out direction or the direction of the second surface pointing to the first surface is the lead-out direction, such that the lead-out structure connected to the third signal line 204 and the lead-out structure connected to the fourth signal line 206 are led out on the same side, which is convenient for fabrication.

For example, for each of the third signal line 204 and the fourth signal line 206, the first surface of the lead-out end may be the lead-out surface, or for each of the third signal line 204 and the fourth signal line 206, the second surface of the lead-out end may be the lead-out surface, so as to be in contact with the first end of the lead-out structure (i.e., a start end of the lead-out direction) to achieve the electrical connection, but is not limited thereto, and a groove or a through-hole may also be provided in the lead-out end of each of the third signal line 204 and the fourth signal line 206, so that the first end of the lead-out structure may be embedded in the groove or the through-hole to be contact with the lead-out end of each of the third signal line 204 and the fourth signal line 206 to achieve the electrical connection.

In this embodiment, the extension lengths of the third signal line 204 and the fourth signal line 206 may be designed differently, i.e., the extension lengths of the signal lines located in different layers and extending in the same direction may be designed differently, so that the portion of the longer signal line in the plurality of signal lines located in different layers and extending in the same direction may be uncovered by the shorter signal line, and it should be noted that the uncovered portion is the lead-out end, such that the plurality of signal lines located in different layers and extending in the same direction are arranged in a staircase manner, so as to facilitate the signal lines of each layer to be led out through different lead-out structures.

The stacking positions of the longer signal line and the shorter signal line extending in the same direction may be determined according to a specific position of the lead-out surface (i.e., the lead-out direction). Exemplarily, for each of the third signal line 204 and the fourth signal line 206, when the direction of the second surface pointing to the first surface is the lead-out direction, the extension length of the third signal line 204 is less than the extension length of the fourth signal line 206 in the same functional layer 20; or for each of the third signal line 204 and the fourth signal line 206, when the direction of the first surface pointing to the second surface is the lead-out direction, the extension length of the fourth signal line 206 is less than the extension length of the third signal line 204 in the same functional layer 20.

Optionally, for each of the third signal line 204 and the fourth signal line 206, two opposite ends of the body extension portion is provided with lead-out ends in the second horizontal direction Y, facilitating connection with the control circuit.

When the plurality of the functional layers 20 are provided, in two adjacent layers of the functional layer 20, for each of the third signal line 204 and the fourth signal line 206, when the direction of the second surface pointing to the first surface is the lead-out direction, the length of the third signal line 204 in the functional layer 20 away from the substrate 10 is greater than the length of the fourth signal line 206 in the functional layer 20 close to the substrate 10; or, for each of the third signal line 204 and the fourth signal line 206, the direction of the first surface pointing to the second surface is the lead-out direction, the length of the third signal line 204 in the functional layer 20 away from the substrate 10 is less than the length of the fourth signal line 206 in the functional layer 20 close to the substrate 10.

In addition, the semiconductor device may also include a first lead-out structure S1, a second lead-out structure S3, a third lead-out structure S2, and a fourth lead-out structure S4 spaced apart from each other. The first lead-out structure S1 to the fourth lead-out structure S4 all extend in the vertical direction Z and extend in different lengths.

One end (i.e., a start end of the lead-out direction may also be defined as a first end) of the first lead-out structure S1 is in contact with the lead-out end of the first signal line 203, and another end (i.e., a terminal end of the lead-out direction may also be defined as a tail end) of the first lead-out structure S1 extends in the lead-out direction and passes through each insulation film layer. One end (i.e., a start end of the lead-out direction may also be defined as a first end) of the second lead-out structure S3 is in contact with the lead-out end of the second signal line 205, and another end of the second lead-out structure S3 (i.e., the terminal end of the lead-out direction may also be defined as the tail end) extends in the lead-out direction and passes through each insulation film layer. One end of the third lead-out structure S2 (i.e., the start end of the lead-out direction may also be defined as the first end) is in contact with the lead-out end of the third signal line 204, and another end of the third lead-out structure S2 extends in the lead-out direction and passes through each insulation film layer. One end (i.e., a start end of the lead-out direction, which may also be defined as a first end) of the fourth lead-out structure S4 is in contact with the lead-out end of the fourth signal line 206, and another end of the fourth lead-out structure S4 (i.e., a terminal end of the lead-out direction may also be defined as a tail end) extends in the lead-out direction and passes through each insulation film layer.

A specific embodiment of the present disclosure is described in detail below in combination with FIGS. 1 to 5.

The functional layer 20 may include a plurality of memory units 20a, and as shown in FIGS. 2 and 3, the plurality of memory units 20a may be arranged in an array in the first horizontal direction X and the second horizontal direction Y, so that the functional layer 20 is an array-type storage structure, which may increase the memory density of each functional layer 20, but is not limited thereto, and the functional layer 20 may also include a single memory unit 20a, which is determined as actual situation.

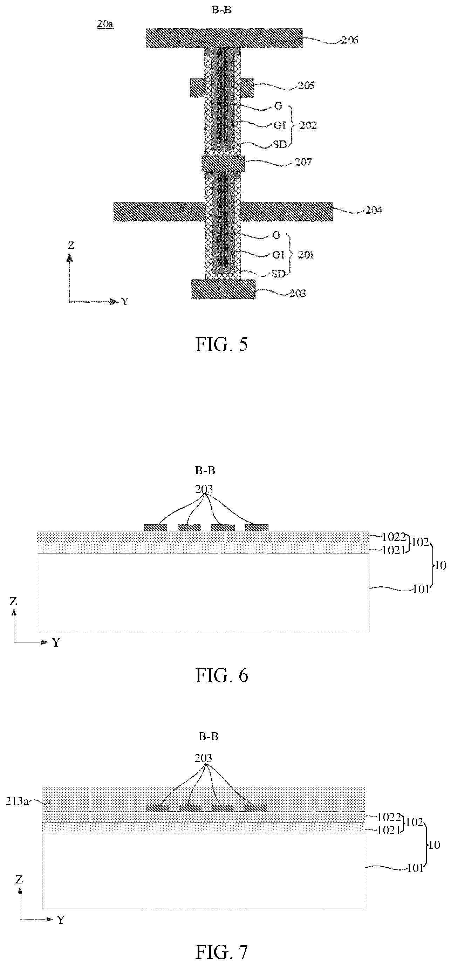

In this embodiment, the memory unit 20a may be a 2T0C structure. Specifically, as shown in FIGS. 4 and 5, the memory unit 20a may include at least a first transistor structure 201, a second transistor structure 202, a first signal line 203, a third signal line 204, a second signal line 205, and a fourth signal line 206.

The first signal line 203, the third signal line 204, the second signal line 205, and the fourth signal line 206 each includes a body extension portion (not shown in the figures) and a lead-out end (not shown in the figures), and as shown in FIGS. 2 and 3, the lead-out ends of the first signal line 203, the third signal line 204, the second signal line 205, and the fourth signal line 206 are located at two opposite ends of their body extension portions in the their extension directions for connecting to the lead-out structure.

In addition, the first transistor structure 201 is connected to the body extension portion of the first signal line 203 and the body extension portion of the third signal line 204. The second transistor structure 202 is connected to the body extension portion of the second signal line 205 and the body extension portion of the fourth signal line 206. One or more of the first signal line 203, the third signal line 204, the second signal line 205, and the fourth signal line 206 are used to receive level signals output from the control circuit or output level signals to the reading circuit through the lead-out structure, so that the memory unit 20a to be read and written is selected in the functional layer 20, thereby realizing a read and write operation of the data.

As shown in FIGS. 4 and 5, the first transistor structure 201 and the second transistor structure 202 each includes a channel portion SD and a gate portion G insulated from the channel portion SD. Specifically, a gate insulation portion GI is formed between the channel portion SD and the gate portion G. It should be appreciated that the channel portion SD includes a first connection region, a second connection region, and a channel region located between the first connection region and the second connection region (not marked in the figures), one of the first connection region and the second connection region is a source region and the other is a drain region. And the gate portion G includes a gate region, specifically, the gate portion G as a whole may be understood as a gate region.

The first connection region of the first transistor structure 201 is connected to the body extension portion of the first signal line 203. For example, the first connection region of the first transistor structure 201 may be in direct contact with the body extension portion of the first signal line 203, but is not limited thereto, or may be indirectly electrically connected by other conductive structures. The second connection region of the first transistor structure 201 is connected to the body extension portion of the third signal line 204, for example, the second connection region of the first transistor structure 201 may be in direct contact with the body extension portion of the third signal line 203, but is not limited thereto, or may be indirectly electrically connected by other conductive structures. The first connection region of the second transistor structure 202 is connected to the gate region of the first transistor structure 201, for example, the first connection region of the second transistor structure 202 may be in direct contact with the gate region of the first transistor structure 201, or the first connection region of the second transistor structure 202 may be indirectly electrically connected to the gate region of the first transistor structure 201 by in contact with the conductive contact pad 207. The second connection region of the second transistor structure 202 is connected to the body extension portion of the second signal line 205, for example, the second connection region of the second transistor structure 202 may be in direct contact with the body extension portion of the second signal line 205, but is not limited thereto, or may be indirectly electrically connected by other conductive structures. The gate region of the second transistor structure 202 is connected to the body extension portion of the fourth signal line 206, for example, the gate region of the second transistor structure 202 may be in direct contact with the body extension portion of the fourth signal line 206, but is not limited thereto, or may be indirectly electrically connected by other conductive structures.

The memory unit 20a of the present embodiment adopts a 2T0C structure, which, compared to the 1T1C storage structure, ensures the storage performance of a single memory unit 20a while reducing the area occupied by the single memory unit 20a, thereby appropriately increasing the number of memory units 20a in each the functional layer 20, to increase the memory density of each functional layer 20, and subsequently increase the memory density of the entire semiconductor device.

Exemplarily, in the same functional layer 20, the first signal line layer, the third signal line layer, the second signal line layer, and the fourth signal line layer are stacked with each other and two adjacent signal line layers are insulated from each other by an insulation film layer, to reduce the crosstalk occurring in the signals of the first transistor structure 201 and the second transistor structure 202 while reducing the area occupied by the memory unit 20a.

It should be noted that a stacked arrangement in this embodiment refers to that the structures are located in different film layers and the film layers are stacked in one direction, and the insulation from each other in this embodiment refers to that an insulation film layer is provided between two adjacent structures.

For example, the material of the first signal line 203, the third signal line 204, the second signal line 205, and the fourth signal line 206 may include one or more of titanium nitride (TiN), titanium (Ti), gold (Au), tungsten (W), molybdenum (Mo), indium tin oxide (ITO), aluminum (Al), copper (Cu), ruthenium (Ru), silver (Ag) and other electrically conductive materials. The insulation material may include one or more of silicon dioxide (SiO₂), aluminum oxide (Al₂O₃), hafnium dioxide (HfO₂), titanium dioxide (TiO₂₎, silicon nitride (SiN) and other materials.

In the same functional layer 20, the first signal line 203 and the second signal line 205 are extendable in the first horizontal direction X, and the third signal line 204 and the fourth signal line 206 are extendable in the second horizontal direction Y Since the extension directions of the first signal line 203 and the third signal line 204 are designed to be different, and the extension directions of the second signal line 205 and the fourth signal line 206 are designed to be different, which reduces the difficulty in designing and controlling the functional layer 20 while realizing the control of the transistor. In addition, the parasitic capacitance generated between the two signal lines connected to the transistor can be reduced. Since the extension directions of the first signal line 203 and the second signal line 205 are designed to be the same, and the extension directions of the third signal line 204 and the fourth signal line 206 are designed to be the same, so as to further reduce the design difficulty of the memory unit 20a and reduce its occupied area.

Further, the first horizontal direction X and the second horizontal direction Y are perpendicular to each other to reduce the area occupied by the memory unit 20a.

In addition, when the functional layer 20 includes a plurality of memory units 20a arrayed in the first horizontal direction X and the second horizontal direction Y, the plurality of memory units 20a arrayed in the first horizontal direction X share a first signal line 203 and a second signal line 205 extending in the first horizontal direction X, as shown in FIG. 2. The plurality of memory units 20a arrayed in the second horizontal direction Y share a third signal line 204 and a fourth signal line 206 extending in the second horizontal direction Y, in order to reduce the difficulty of controlling the functional layer 20, thereby reducing the cost.

Since the first signal line layer and the second signal line layer in the functional layer 20 are stacked, and the first signal line 203 and the second signal line 205 are extended in the same direction, and the third signal line layer and the fourth signal line layer are stacked, and the third signal line 204 and the fourth signal line 206 are extended in the same direction, in order to independently lead out the signal lines in the functional layer 20 which are located in different layers and extend in the same direction, the present embodiment may design the lengths of the signal lines which are located in different layers and extend in the same direction to be different, i.e., the extension lengths of the second signal line 205 and the first signal line 203 are different, and the extension lengths of the fourth signal line 206 and the third signal line 204 are different, so that the portions of the longer signal lines in the plurality of signal lines located in different layers and extending in the same direction are uncovered by the shorter signal lines, such that the plurality of signal lines located in different layers and extending in the same direction are arranged in a staircase manner, to facilitate the signal lines of each layer to be led out.

As shown in combination with FIGS. 1 to 3, each functional layer 20 is correspondingly provided with a first lead-out structure S1, a third lead-out structure S2, a second lead-out structure S3, and a fourth lead-out structure S4 arranged at intervals. The lead-out end of the first signal line 203 is in contact with the first lead-out structure S1, the lead-out end of the third signal line 204 is in contact with the third lead-out structure S2, and the lead-out end of the second signal line 205 is in contact with the second lead-out structure S3, the lead-out end of the fourth signal line 206 is in contact with the fourth lead-out structure S4. Each signal line may be connected to the control circuit or the reading circuit through the lead-out structure, so as to realize the independent lead-out of the signal lines in the memory unit 20a.

It should be noted that the location where the lead-out end of the aforementioned signal line is in contact with the lead-out structure may be the lead-out surface (i.e., the aforementioned first surface or the second surface). In this case, the insulation film layer formed on the side where the lead-out surface of the signal line is located may be penetrated by its corresponding lead-out structure.

Referring to FIGS. 2 and 3, in the same functional layer 20, the first signal line layer, the third signal line layer, the second signal line layer, and the fourth signal line layer are stacked in the vertical direction Z.

In this embodiment, the first horizontal direction X and the second horizontal direction Y are parallel to the substrate 10, and the vertical direction Z is perpendicular or nearly perpendicular to the substrate 10, that is to say, the extension directions of the first signal line 203, the third signal line 204, the second signal line 205 and the fourth signal line 206 are parallel to the substrate 10. And the first signal line layer, the third signal line layer, the second signal line layer and the fourth signal line layer are stacked in a direction perpendicular to the substrate 10, which reduces the difficulty of production and the design cost.

In addition, as shown in FIGS. 2 to 5, when the first signal line layer, the third signal line layer, the second signal line layer, and the fourth signal line layer are stacked in the vertical direction Z, the first transistor structure 201 and the second transistor structure 202 may also be stacked on the substrate 10 in the vertical direction Z, which reduces the area occupied by the memory unit 20a, and thus improves the overall memory density of the functional layer 20.

When the direction of the first surface pointing to the second surface in each signal line is the lead-out direction, that is to say, when the second signal line 205 is formed by the lead-out side of the first signal line 203 and the fourth signal line 206 is formed by the lead-out side of the third signal line 204. As shown in FIG. 2, an extension length of the second signal line 205 is less than an extension length of the first signal line 203, and as shown in FIG. 3, the extension length of the fourth signal line 206 is less than the extension length of the third signal line 204, in order to facilitate that each signal line is led out through the independent lead-out structure.

It should be noted that the orthographic projection in the embodiments of the present disclosure refers to a projection generated by projecting in a direction perpendicular to the substrate 10.

Optionally, in the same functional layer 20, the orthographic projections of two opposite ends of the second signal line 205 in the first horizontal direction X on the substrate 10 are located within the orthographic projection of the first signal line 203 on the substrate 10. The orthographic projections of two opposite ends of the fourth signal line 206 in the second horizontal direction Y on the substrate 10 are located within the orthographic projection of the third signal line 204 on the substrate 10.

Further, in the same functional layer 20, as shown in FIG. 2, two opposite edges of the first signal line 203 in the first horizontal direction X do not overlap with the orthographic projection of the second signal line 205 on the substrate 10, that is to say, two opposite edges of the first signal line 203 in the first horizontal direction X on a side away from the substrate 10 are uncovered by the second signal line 205, and two opposite edges of the first signal line 203 in the first horizontal direction X can be led out through the first lead-out structure S1. As shown in FIG. 3, two opposite edges of the third signal line 204 in the second horizontal direction Y do not overlap with the orthographic projection of the fourth signal line 206 on the substrate 10, that is to say, two opposite edges of the third signal line 204 in the second horizontal direction Y on a side away from the substrate 10 are uncovered by the fourth signal line 206, two opposite edges of the third signal line 204 in the second horizontal direction Y can be led out through the third lead-out structure S2, which facilitates the connection of the memory unit 20a with its peripheral circuits.

With continued reference to FIG. 2, it is shown that two opposite edges of the second signal line 205 in the first horizontal direction X may be led out through the second lead-out structure S3. With continued reference to FIG. 3, it is shown that two opposite edges of the fourth signal line 206 in the second horizontal direction Y may be led out through the fourth lead-out structure S4.

It is worthy of note that two opposite edges herein refer to the lead-out ends of each signal line located at two opposite ends of the body extension portion in its extension direction.

In addition, it is also noted that, with reference to FIG. 3, the number of the first signal lines 203 may be equal to the number of the second signal lines 205, and the first signal lines 203 correspond to the second signal lines 205 one-in-one in the vertical direction Z. With reference to FIG. 2, the number of the third signal lines 204 may be equal to the number of the fourth signal lines 206, and the third signal lines 204 correspond to the fourth signal lines 206 one-in-one in the vertical direction Z. But is not limited thereto, and the number may also be unequal, which is determined as actual.

In addition, the widths and/or thicknesses of the first signal line 203, the third signal line 204, the second signal line 205, and the fourth signal line 206 may be designed to be equal, but is not limited thereto, and the widths and/or thicknesses of the first signal line 203, the third signal line 204, the second signal line 205, and the fourth signal line 206 may also be designed to be slightly different based on the actual situation, which is determined based on the actually required performance of the semiconductor device and processing conditions.

In this embodiment, the direction of the lead-out end in the signal line away from the substrate 10 may be defined as the lead-out direction. When the direction of the lead-out end in the signal line away from the substrate 10 is the lead-out direction, as shown in FIGS. 2 and 3, the second signal line 205 may be formed by the side of the first signal line 203 away from the substrate 10, and the fourth signal line 206 may be formed by the side of the third signal line 204 away from the substrate 10. The direction of the lead-out end of the signal line away from the substrate 10 is designed as the lead-out direction, such that the first lead-out structure S1, the third lead-out structure S2, the second lead-out structure S3, and the fourth lead-out structure S4 may be formed uniformly after each of the film layers is formed in the functional layer 20, which may reduce the difficulty of fabrication and improve the efficiency of fabrication while realizing the independent lead-out of each of the signal lines.

It should be understood that when the direction of the lead-out end in the signal line away from the substrate 10 may be the lead-out direction, the end of the lead-out structure away from the substrate 10 may be connected to the control circuit or other circuits.

When the direction of the lead-out end in the signal line away from the substrate 10 is the lead-out direction, the first signal line 203 and the third signal line 204 may be designed to be closer to the substrate 10 as compared to the second signal line 205 and the fourth signal line 206. The first transistor structure 201 may be designed to be closer to the substrate 10 as compared to the second transistor structure 202, so as to facilitate that the first signal line 203 and the third signal line 204 are connected to the first transistor structure 201, and the second signal line 205 and the fourth signal line 206 are connected to the second transistor structure 202.

As shown in FIGS. 2 to 5, the first signal line layer, the third signal line layer, the second signal line layer, and the fourth signal line layer are sequentially stacked on the substrate 10 when the direction of the lead-out end in the signal line away from the substrate 10 is the lead-out direction, such that the extension directions of the adjacent signal lines in the functional layer 20 in the vertical direction Z are different from one another to reduce the parasitic capacitance generated between the adjacent signal lines.

It should be noted that the present embodiment is not limited to designing the direction in which the lead-out ends of the signal lines are away from the substrate 10 as the lead-out direction, but may also design the direction in which the lead-out ends of the signal lines are close to the substrate 10 as the lead-out direction, e.g., when the direction in which the lead-out ends of the signal lines are close to the substrate 10 is the lead-out direction, the extension length of the second signal line 205 may be greater than the extension length of the first signal line 203, the extension length of the fourth signal line 206 may be greater than the extension length of the third signal line 204. In this case, the lead-out structure may be uniformly formed on the side of the substrate 10 after each film layer of the functional layer 20 is formed in turn.

Furthermore, taking the direction in which the lead-out ends of the signal lines are away from the substrate 10 as the lead-out direction as an example, when the plurality of the functional layers 20 are provided in the semiconductor device and are sequentially stacked on the substrate 10 in the vertical direction Z, in two adjacent functional layers 20, as shown in FIG. 2, the extension length of the first signal line 203 in the functional layer 20 away from the substrate 10 is less than the extension length of the second signal line 205 in the functional layer 20 close to the substrate 10; as shown in FIG. 3, the extension length of the third signal line 204 in the functional layer 20 away from the substrate 10 is less than the extension length of the fourth signal line 206 in the functional layer 20 close to the substrate 10, in order to facilitate that the signal lines located in different layers in the entire semiconductor device and extending in the same direction are led out independently.

In other words, when the direction in which the lead-out ends of the signal lines are away from the substrate 10 is the lead-out direction, the extension lengths of the signal lines located in different layers in the entire semiconductor device and extending in the same direction are sequentially reduced in the direction away from the substrate 10.

In order to protect the structure of each memory unit 20a in the functional layer 20, the functional layer 20 further includes an insulation film layer covering the memory unit 20a.

As shown in FIGS. 2 and 3, in the functional layer 20, a first lead-out structure S1 passes through each insulation film layer on its lead-out direction side, a third lead-out structure S2 passes through each insulation film layer on its lead-out direction side; a second lead-out structure S3 passes through each insulation film layer on its lead-out direction side; and a fourth lead-out structure S4 passes through each insulation film layer on its lead-out direction side.

The first lead-out structure S1, the third lead-out structure S2, the second lead-out structure S3, and the fourth lead-out structure S4 all extend in the vertical direction Z and have different extension lengths, and it should be understood that the closer the signal line to the substrate 10 in the vertical direction Z, the greater the extension length of the corresponding lead-out structure.

After the plurality of the functional layers 20 are sequentially stacked on the substrate 10, the first lead-out structure S1, the third lead-out structure S2, the second lead-out structure S3, and the fourth lead-out structure S4 corresponding to each of the functional layers 20 are then uniformly formed to simplify the processing steps and reduce the cost.

In this embodiment, the second connection region of the channel portion SD in the transistor structure may be located by a side of the channel region away from the first connection region, that is, the channel region of the channel portion SD may be extended in the vertical direction Z, such that the memory density can be improved and the leakage current can be reduced by increasing the length of the channel region without increasing the horizontal area of the memory unit 20a. As shown in FIGS. 2 to 5, the gate portion G is provided at least opposite to the channel portion SD in a direction parallel to the substrate 10.

Optionally, the channel portion SD and the gate portion G are made of semiconductor materials, and the gate portion G is made of a semiconductor material, which is easy to control the critical voltage of the transistor structure and has fewer defects on the contact surface.

The semiconductor material may be one of Indium Gallium Zinc Oxide (IGZO), Indium Zinc Oxide (IZO), and Indium Tin Oxide (ITO), which is conducive to lowering the leakage current of the transistor structure and lowering the power consumption of the transistor structure, but it is not limited thereto, and it may also be other semiconductor materials such as silicon.

It should be understood that the semiconductor materials of the channel portion SD and the gate portion G may or may not be the same, and by way of example, the semiconductor material of the channel portion SD may include IGZO and the semiconductor material of the gate portion G may include IZO.

Exemplarily, the first connection region of the channel portion SD of the first transistor structure 201 is formed between the gate portion G of the first transistor structure 201 and the first signal line 203, and the channel region and the second connection region of the channel portion SD of the first transistor structure 201 are provided around the gate portion G of the first transistor structure 201. It is to be appreciated that the channel region and the second connection region of the channel portion SD of the first transistor structure 201 are not limited to being provided around the gate portion G of the first transistor structure 201, but may also be provided at two opposite sides of the gate portion G. The first connection region of the channel portion SD of the second transistor structure 202 is formed between the gate portion G of the second transistor structure 202 and the gate portion G of the first transistor structure 201, and the channel region and the second connection region of the second transistor structure 202 are provided around the gate portion G of the second transistor structure 202, that is to say, the cross-section of the channel portions SD of the first transistor structure 201 and the second transistor structure 202 in the vertical direction Z may be understood to be a U-shape. Such design, with respect to the flat plate type of the vertical transistors, can increase the length of the channel regions of the first transistor structure 201 and the second transistor structure 202 while the horizontal area remains unchanged, so as to increase the memory density.

Optionally, as shown in FIGS. 2 to 5, the third signal line 204 is provided around the second connection region of the first transistor structure 201, and the second signal line 205 is provided around the second connection region of the second transistor structure 202, to increase the integration density of the semiconductor structure.

In this embodiment, a conductive contact pad 207 is formed between the first connection region of the channel portion SD of the second transistor structure 202 and the gate portion G of the first transistor structure 201. Orthographic projections of the gate portions G of the first transistor structure 201 and the second transistor structure 202 on the substrate 10 overlap with an orthographic projection of the conductive contact pad 207 on the substrate 10. Further, orthographic projections of the gate portions G of the first transistor structure 201 and the second transistor structure 202 on the substrate 10 may be located within the orthographic projection of the conductive contact pad 207 on the substrate 10. The conductive contact pad 207 is provided to facilitate ensuring the area of the electrical conduction between the gate portion G of the first transistor structure 201 and the first connection region of the second transistor structure 202, so as to ensure the working performance of the memory unit 20a.

Embodiments of the present disclosure also provide a method of manufacturing a semiconductor device for manufacturing the semiconductor device described in any of the foregoing embodiments. The method of manufacturing the semiconductor device may include providing a substrate 10 and forming at least one functional layer 20 on the substrate 10. The arrangement relationship, the structure shapes, the length relationship, and the lead-out direction between the structures in the functional layer 20, etc. may be referred to the contents recited in FIGS. 1 to 5 and described in any of the foregoing embodiments, and will not be repeated herein.

In this embodiment, the forming the functional layer 20 may include:
step S1, forming a first signal line layer and a first insulation film layer 209 covering the first signal line 203 on the substrate 10. The first signal line 203 extends in a first horizontal direction X;
step S2, forming a second signal line layer with the second signal lines 205 extending in the first horizontal direction X on a side of the first insulation film layer 209 away from the substrate 10.

In this embodiment, the forming the functional layer 20 may further include:
before forming the second signal line layer, sequentially forming a third signal line layer, a second insulation film layer 210, a fourth signal line layer and a third insulation film layer 212 on a side of the first insulation film layer 209 away from the substrate 10. The third signal line 204 and the fourth signal line 206 each extends in a second horizontal direction Y, the third signal line layer and the fourth signal line layer are insulated from each other by the second insulation film layer 210, the fourth signal line layer and the second signal line layer are insulated from each other by the third insulation film layer 212; or
before forming the second signal line layer, sequentially forming a third signal line layer and a second insulation film layer 210 on the side of the first insulation film layer 209 away from the substrate 10, and after forming the second signal line layer, sequentially forming the third insulation film layer 212 and the fourth signal line layer. The third signal line 204 and the fourth signal line 206 extend in the second horizontal direction Y, the third signal line layer and the second signal line layer are insulated from each other by the second insulation film layer 210, the second signal line layer and the fourth signal line layer are insulated from each other by the third insulation film layer 212.

The method of manufacturing the embodiment of the present disclosure is described in detail below in connection with FIGS. 1 to 43.

The forming the functional layer 20 on the substrate 10 may specifically include step S100, step S102, step S104, step S106, step S108, step S110, step S112, step S114, step S116, etc.

In step S100, the first signal line layer and the first insulation film layer 209 covering the first signal line layer are sequentially formed on the substrate 10.

By way of example, when the substrate 10 includes a semiconductor substrate 101 and an insulating isolation layer 102 formed on the semiconductor substrate 101, forming the first signal line layer on the substrate 10 may be understood as forming the first signal line layer on a side of the insulating isolation layer 102 away from the semiconductor substrate 101.

Exemplarily, the forming the first signal line layer may specifically include: step S1001, step S1002, and step S1003.

In step S1001, a plurality of first signal lines 203 spaced apart in the second horizontal direction Y are formed in the substrate 10, as shown in FIG. 6.

In step S1002, a first isolation material film 213a is formed, and the first isolation material film 213a covers each first signal line 203 and is filled in between adjacent first signal lines 203, as shown in FIG. 7.

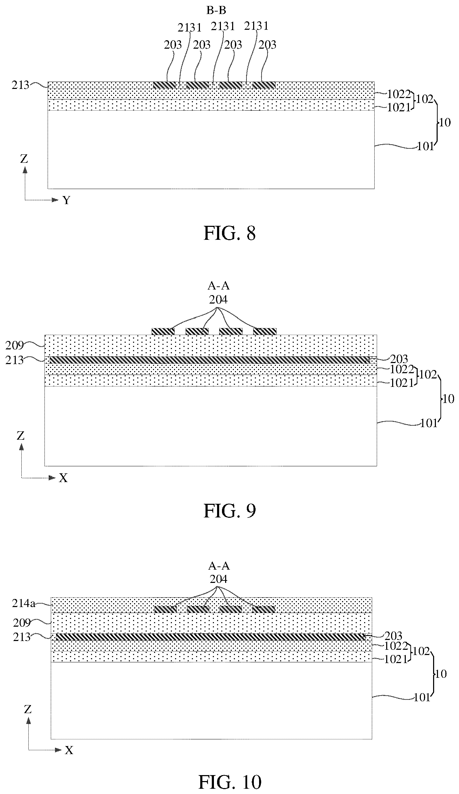

In step S1003, a portion of the first isolation material film 213a higher than the first signal line 203 is removed and a first isolation pattern layer 213 is formed. A surface of the first isolation pattern layer 213 away from the substrate 10 is flush with a surface of the first signal line 203 away from the substrate 10, that is, a surface of the first signal line 203 away from the substrate 10 is opened, and the first isolation pattern layer 213 includes at least a first isolation portion 2131 filled between adjacent first signal lines 203, as shown in FIG. 8.

After performing step S1003, the first insulation film layer 209 covering the first signal line layer is then formed.

In step S102, the third signal line layer and the second insulation film layer 210 covering the third signal line layer are sequentially formed on the side of the first insulation film layer 209 away from the substrate 10, and the orthographic projection of the body extension portion of the third signal line 204 is overlapped with the orthographic projection of the body extension portion of the first signal line 203 on the substrate 10.

Exemplarily, the forming the third signal line layer may specifically include: step S1021, step S1022, and step S1023.

In step S1021, a plurality of third signal lines 204 spaced apart in a first horizontal direction X are formed on a side of the first insulation film layer 209 away from the substrate 10, as shown in FIG. 9.

In step S1022, a second insulation material film 214a is formed, and the second insulation material film 214a covers each third signal line 204 and is filled in between adjacent third signal lines 204, as shown in FIG. 10.

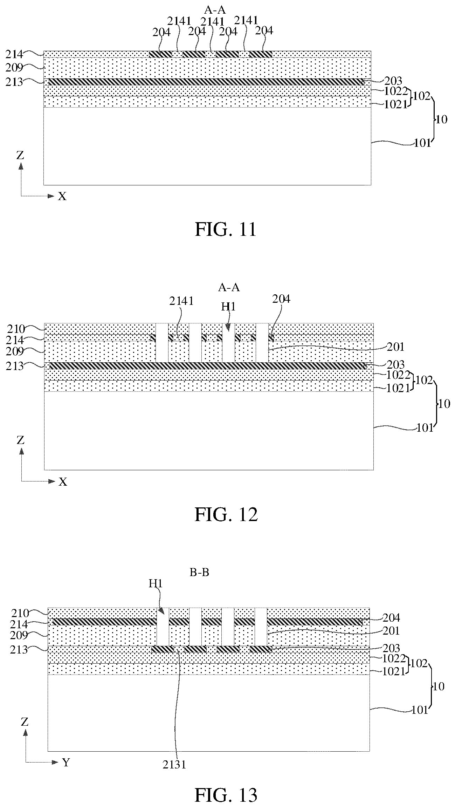

In step S1023, a portion of the second isolation material film 214a higher than the third signal line 204 is removed and a second isolation pattern layer 214 is formed. A surface of the second isolation pattern layer 214 away from the substrate 10 is flush with a surface of the third signal line 204 away from the substrate 10, i.e., a surface of the third signal line 204 away from the substrate 10 is opened, and the second isolation pattern layer 214 includes at least a second isolation portion 2141 filled between adjacent third signal lines 204, as shown in FIG. 11.

After performing step S1023, the second insulation film layer 210 covering the third signal line layer is formed.

In step S104, a first through-hole H1 is formed that passes sequentially through the second insulation film layer 210, the body extension portion of the third signal line 204, and the first insulation film layer 209. The first through-hole H1 opens the surface of the body extension portion of the first signal line 203 away from the substrate 10, as shown in FIGS. 12 and 13.

As shown in FIGS. 12 and 13, in a front projection on the substrate 10, the first through-hole H1 is located within the intersection of the body extension portion of the first signal line 203 with the body extension portion of the third signal line 204 to reduce the difficulty of connecting subsequently the first transistor structure 201 to the first signal line 203 and the third signal line 204.

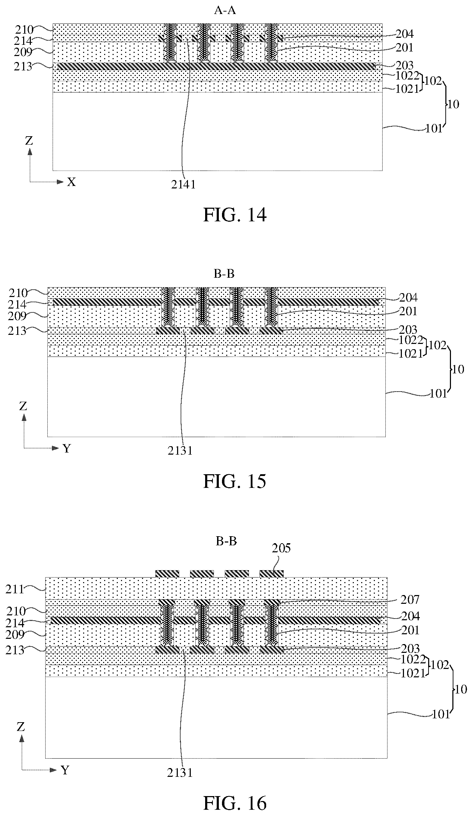

In step S106, the first transistor structure 201 is formed within the first through-hole H1, the first connection region of the first transistor structure 201 is in contact with the body extension portion of the first signal line 203, and the second connection region of the first transistor structure 201 is in contact with the body extension portion of the third signal line 204, as shown in FIGS. 14 and 15.

In step S108, an interlayer insulation film layer 211 is formed, and covers the first transistor structure 201 and the second insulation film layer 210.

In step S110, the second signal line layer and the third insulation film layer 212 covering the second signal line layer are formed sequentially on a side of the interlayer insulation film layer 211 away from the substrate 10.

Exemplarily, the forming the second signal line layer may specifically include step S1101, step S1102, and step S1103.

In step S1101, a plurality of second signal lines 205 spaced apart in a second horizontal direction Y are formed on the side of the interlayer insulation film layer 211 away from the substrate 10, as shown in FIG. 16.

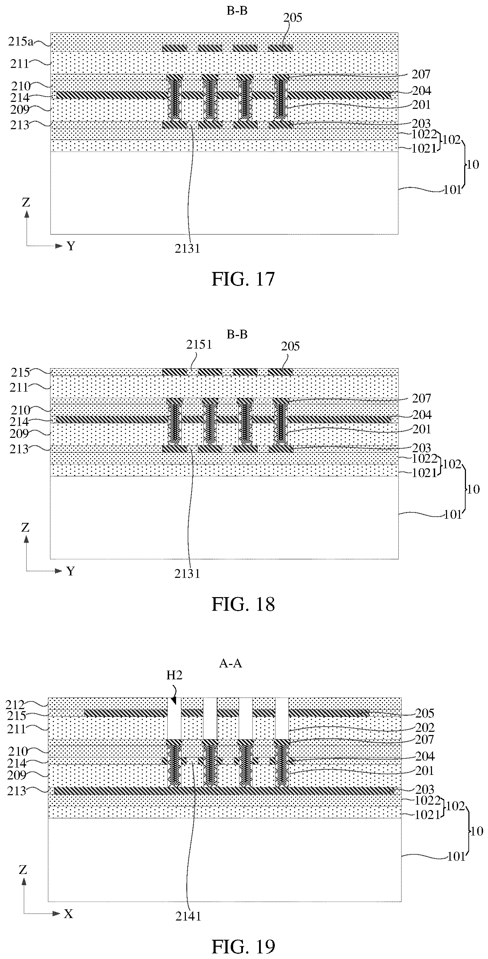

In step S1102, a third isolation material film 215a is formed, and the third isolation material film 215a covers each second signal line 205 and is filled in between adjacent second signal lines 205, as shown in FIG. 17.

In step S 1103, a portion of the third isolation material film 215a higher than the second signal line 205 is removed and a third isolation pattern layer 215 is formed. A surface of the second isolation pattern layer 215 away from the substrate 10 is flush with a surface of the second signal line 205 away from the substrate 10, i.e., a surface of the second signal line 205 away from the substrate 10 is opened, and the third isolation pattern layer 215 includes at least a second isolation portion 2151 filled between adjacent second signal lines 205, as shown in FIG. 18.

After performing step S1103, the third insulation film layer 212 covering the second signal line layer is then formed.

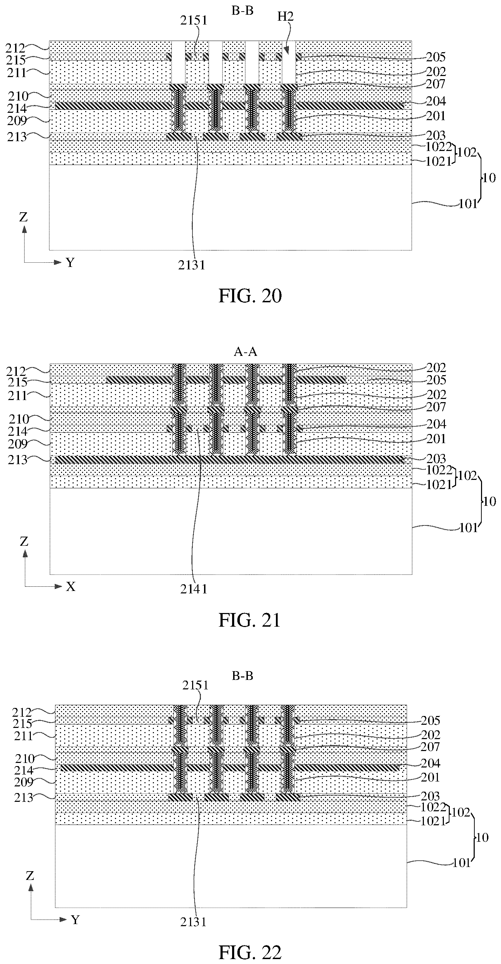

In step S112, a second through-hole H2 is formed that passes sequentially through the third insulation film layer 212, the second signal line layer, and the interlayer insulation film layer 211, and there is an overlap in orthographic projections of the second through-hole H2 and the first through-hole H1 on the substrate 10, as shown in FIGS. 19 and 20.

In step S114, a second transistor structure 202 is formed within the second through-hole H2, a first connection region of the second transistor structure 202 is connected to a gate region (i.e., a gate portion G) of the first transistor structure 201, and the second connection region of the second transistor structure 202 is in contact with a body extension portion of the second signal line 205 as shown in FIGS. 21 and 22.

By way of example, in the front projection on the substrate 10, the second through-hole H2 is located within the intersection of the body extension portion of the second signal line 205 with the body extension portion of the fourth signal line 206, in order to reduce the difficulty of subsequently connecting the second transistor structure 202 to the second signal line 205 and the fourth signal line 206.

Exemplarily, in order to achieve connection of the first connection region of the second transistor structure 202 to the gate region of the first transistor structure 201, the conductive contact pad 207 may be formed before forming the second transistor structure 202.

Specifically, after forming the first transistor structure 201 and before forming the interlayer insulation film layer 211, the manufacturing method further includes: step S 107, forming the conductive contact pad 207. A side of the conductive contact pad 207 close to the substrate 10 is in contact with the gate region of the first transistor structure 201, and the side of the conductive contact pad 207 away from the substrate 10 is in contact with the first connection region of the second transistor structure 202.

It should be noted that, to prevent the channel portion SD of the first transistor structure 201 from being short-circuited with the gate portion G, the conductive contact pad 207 is provided to be insulated from the channel portion SD of the first transistor structure 201. For example, a side of the channel portion SD away from the substrate 10 is covered by the gate insulation portion GI, and the conductive contact pad 207 is insulated from the channel portion SD of the first transistor structure 201 by the gate insulation portion GI, or also other insulation film layers may be provided.

Step S107 may specifically include step S1071, step S1072, step S1073, step S1074, step S1075, step S1076, step S1077.

In step S1071, the first conductive material film 301 and the first sacrificial material film 311 are formed sequentially, and the first conductive material film 301 and the sacrificial material film 311 cover the second insulation film layer 210 and the first transistor structure 201.

By way of example, the first sacrificial material film 311 may include a stacked film with a plurality of film layers, such as, a SOC (Spin-on carbon) film layer and a SiN (silicon nitride) film layer sequentially stacked, but is not limited thereto, the first sacrificial material film 311 may also be a single-layer structure, and the material of the first sacrificial material film 311 may include one or more insulation materials such as silicon oxynitride, silicon oxide, etc.

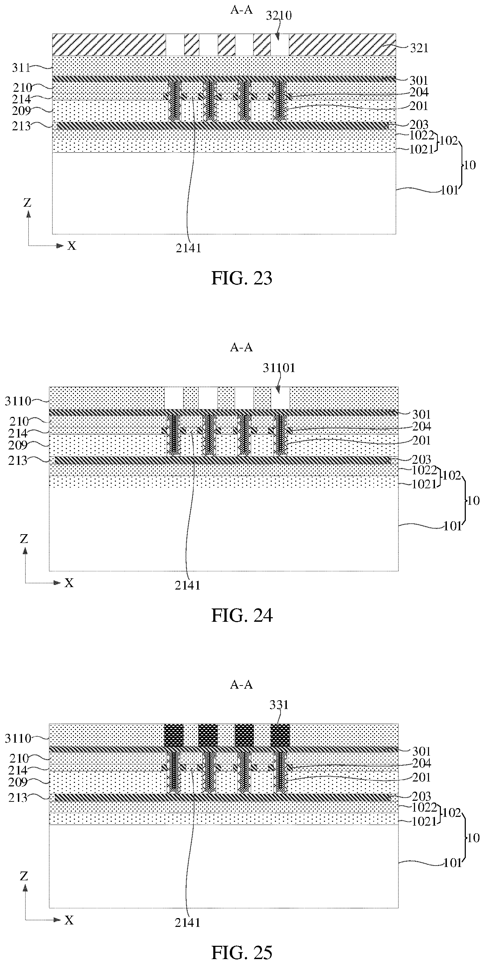

In step S1072, a first photoresist mask pattern layer 321 is formed on a side of the first sacrificial material film 311 away from the first conductive material film 301. The first photoresist mask pattern layer 321 includes a plurality of first photolithographic perforations 3210 arrayed in the first horizontal direction X and the second horizontal direction Y. The first photolithographic perforations 3210 correspond to the first transistor structure 201 one-in-one, as shown in FIG. 23.

In step S1073, the first sacrificial material film 311 is patterned using the first photoresist mask pattern layer 321 to form the first sacrificial pattern layer 3110. The first sacrificial pattern layer 3110 includes a plurality of first sacrificial perforations 31101 spaced apart. The first sacrificial perforations 31101 correspond to the first photolithographic perforations 3210 one-in-one, and the first sacrificial perforations 31101 open a surface of the first conductive material film 301 away from the substrate 10, as shown in FIG. 24.

In step S1074, the first photoresist mask pattern layer 321 is removed, and then the first intermediate mask material film is formed, and the first intermediate mask material film covers the surface of the first sacrificial pattern layer 3110 away from the substrate 10 and is filled within the first sacrificial perforation 31101.

In step S1075, a portion of the first intermediate mask material film higher than the first sacrificial pattern layer 3110 is removed to form a first intermediate mask pattern layer. The first intermediate mask pattern layer includes a plurality of first intermediate mask blocks 331 spaced apart, the first intermediate mask blocks 331 are located within the first sacrificial perforations 31101, and the surfaces of the first intermediate mask blocks 331 away from the substrate 10 are flush with the surface of the first sacrificial pattern layer 3110, as shown in FIG. 25.

In other embodiments, the first sacrificial material film 311 may be a plurality of sublayers. By way of example, when the first sacrificial material film 311 is a SOC film layer and a SiN film layer stacked sequentially, the material of the first intermediate mask material may be SiN. A portion of the SiN film higher than the upper surface of the SOC film layer is removed to achieve reverse silicon nitride deposition. The removal process may be a flattening process, may have the SOC film layer as a stopping layer, and may be a chemical mechanical polishing CMP, but is not limited thereto, the material of the first intermediate mask material film may also be one or more of such as SiON, SiO₂, the removal process may be an alternative process method such as etching, etc., and the removal process may be ended on the upper surface of the first sacrificial material film 311 as a whole, or of any sublayer of the first sacrificial material film 311.

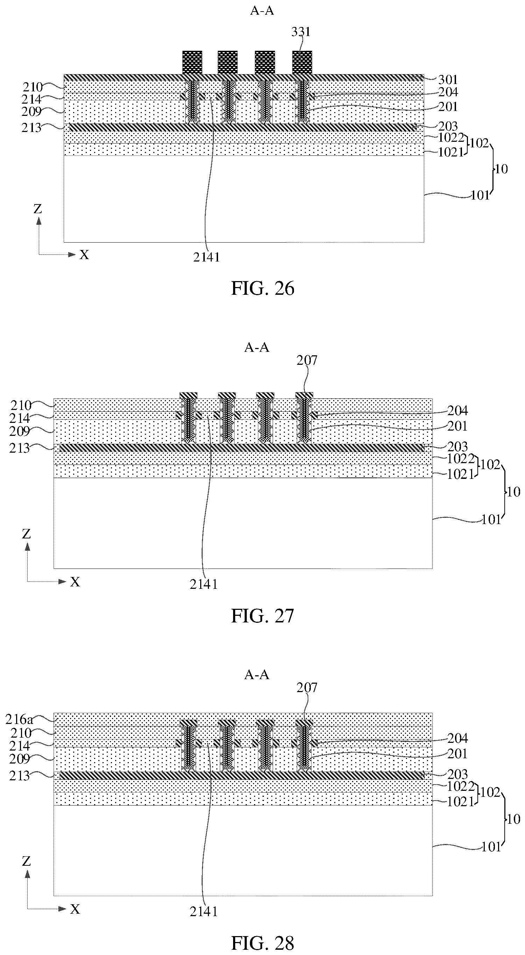

In step S1076, the first sacrificial pattern layer 3110 is removed and the first intermediate mask block 331 is retained, as shown in FIG. 26.

In step S1077, the first conductive material film 301 is patterned using the first intermediate mask block 331 to form a plurality of conductive contact pads 207 spaced apart, the conductive contact pads 207 correspond to the first transistor structure 201 one-in-one, as shown in FIG. 27.

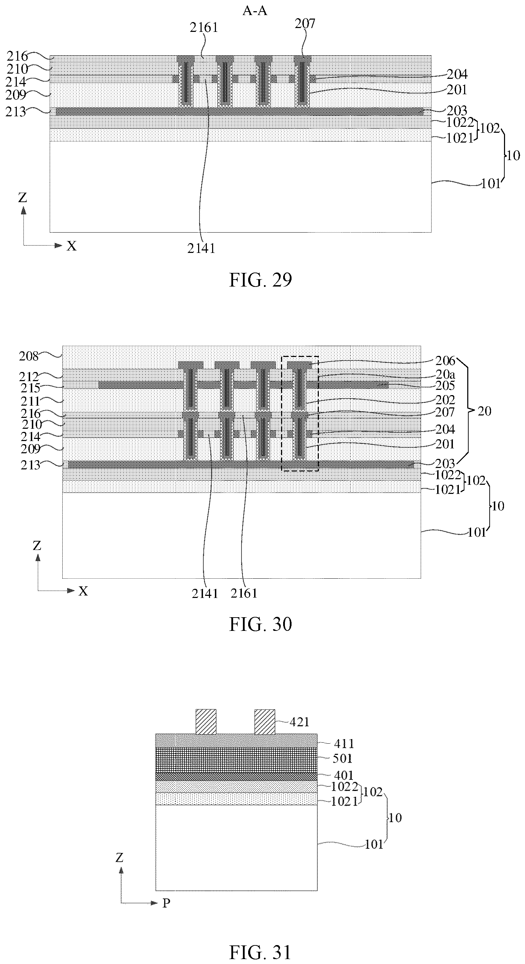

After forming the conductive contact pads 207, and before forming the interlayer insulation film layer 211, the manufacturing method may further include:
forming a fourth isolation material film 216a on a side of the second insulation film layer 210 away from the substrate. The fourth isolation material film 216a covers each of the conductive contact pads 207 and is filled in between adjacent conductive contact pads 207, as shown in FIG. 28.
removing a portion of the fourth isolation material film 216a higher than the conductive contact pads 207 and forming a fourth isolation pattern layer 216. The surface of the fourth isolation pattern layer 216 away from the substrate 10 is flush with the surface of the conductive contact pads 207 away from the substrate 10, i.e., the surfaces of the conductive contact pads 207 away from the substrate 10 are opened, and the fourth isolation pattern layer 216 includes at least a fourth isolation portion 2161 filled in between adjacent conductive contact pads 207, as shown in FIG. 29.

In step S116, the fourth signal line 206 and the fourth insulation film layer 208 covering the fourth signal line 206 are formed on the side of the second transistor structure 202 away from the substrate 10. The body extension portion of the fourth signal line 206 is in contact with the gate region (i.e. the gate portion G) of the second transistor structure 202.

It should be noted that to prevent the channel portion SD of the second transistor structure 202 from being short-circuited with the gate portion G, the body extension portion of the fourth signal line 206 is insulated from the channel portion SD of the first transistor structure 201, for example, the side of the channel portion SD away from the substrate 10 is covered by the gate insulation portion GI, the body extension portion of the fourth signal line 206 is insulated from the channel portion SD of the second transistor structure 202 by the gate insulation portion GI, or other insulation film layers may also be provided.

Based on the foregoing content, it can be noted that in this embodiment, the method of manufacturing the first signal line layer to the fourth signal line layer can be the same. Specifically, the steps of forming the first signal line layer to the fourth signal line layer each can include: first forming a plurality of signal lines (i.e., the conductive pattern layer is first formed) spaced apart; then forming the isolation material film, the isolation material film covers each of the signal lines and is filled in between the adjacent signal lines; thereafter, a portion of the isolation material film higher than the signal lines is removed to open an upper surface of the signal lines and an isolation pattern layer is formed, the surface of the isolation pattern layer away from the substrate is flush with the surface of the signal lines away from the substrate, and the isolation pattern layer includes at least an isolation portion filled in between adjacent signal lines.

It should be noted that after forming the plurality of fourth signal lines 206 spaced apart, the portion of the fourth insulation film layer 208 higher than the fourth signal line layer may not be removed, but is not limited thereto, and the portion of the fourth insulation film layer 208 higher than the fourth signal line layer may be removed first in the same way as the formation of the other first signal line layer to the third signal line layer, and then subsequent fabrication is performed, for example, covering other insulation film layers or conductive layers, etc., which is determined as actual.

In this embodiment, the fabrication of the conductive contact pad 207 and the fourth isolation pattern layer 216 may also be omitted.

In an embodiment, the method of forming the plurality of first signal lines 203, the third signal lines 204, the second signal lines 205, and the fourth signal lines 206 spaced apart may be the same, and specifically, the step of forming the plurality of signal lines (i.e.: the conductive pattern layer) spaced apart may include: step S10, step S 11, step S12, step S13, step S14, step S15, step S16, step S17, step S18, and step S19.

In step 10, the second conductive material film 401, the hard mask material film 501, and the second sacrificial material film 411 are sequentially formed on the substrate 10.

The hardness of the hard mask material film 501 may be greater than the hardness of the second sacrificial material film 411 to ensure collimation for better downward etching.

By way of example, the hard mask material film 501 may be an Amorphous Carbon (A-C) film, but is not limited thereto, other materials may be used. The second sacrificial material film 411 may include a plurality of film layers, for example, including SiON film layers, SOC film layers, SiON film layers, etc. sequentially stacked, but is not limited thereto, and other insulation materials may also be used, and the second sacrificial material film 411 may also be a single-layer film, which is not described in detail herein.

It should be noted that the present embodiment may also omit the production of the hard mask material film 501, which is determined as actual.

In step S11, a second photoresist mask pattern layer is formed on a side of the second sacrificial material film 411 away from the substrate 10, and the second photoresist mask pattern layer includes a plurality of photoresist mask strips 421 spaced apart in the P direction, as shown in FIG. 31.

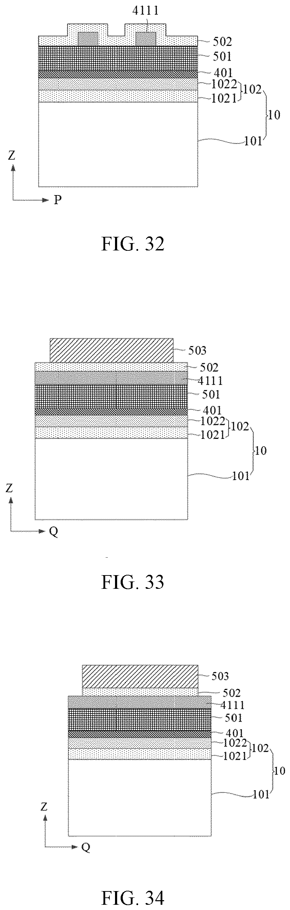

In step S12, the second sacrificial material film 411 is patterned using the second photoresist mask pattern layer to form a second sacrificial pattern layer. As shown in FIG. 32, the second sacrificial pattern layer includes a plurality of sacrificial mask strips 4111 spaced apart in the P direction, the sacrificial mask strips 4111 correspond to the photoresist mask strips 421 one-in-one.

In step S13, the second photoresist mask pattern layer is removed, after which an intermediate mask material film 502 covering each of the sacrificial mask strips 4111 is formed, as shown in FIG. 32.

By way of example, the material of the intermediate mask material film 502 may be SiO₂, but is not limited thereto, and may also be an insulation material such as SiON, SiN.

In step S14, a trimming mask layer 503 is formed on a side of the intermediate mask material film 502 away from the substrate 10. At least one edge region of the sacrificial mask strip 4111 in its extension direction (e.g., the Q direction of FIG. 33) is uncovered by the trimming mask layer 503, as shown in FIG. 33.

By way of example, this trimming mask layer 503 may be a photoresist treated by a photolithography process, but is not limited thereto, and may be other materials, which are not described herein in excess.

In step S15, the portion of the intermediate mask material film 502 uncovered by the trimming mask layer 503 is removed using the trimming mask layer 503, as shown in FIG. 34. In this case, the portion of the sacrificial mask strip 4111 uncovered by the trimming mask layer 503 is opened, but is not limited thereto, at this step, in addition to the portion of the intermediate mask material film 502 uncovered by the trimming mask layer 503 will be removed, the portion of the sacrificial mask strip 4111 uncovered by the trimmed mask layer 503 may also be removed.

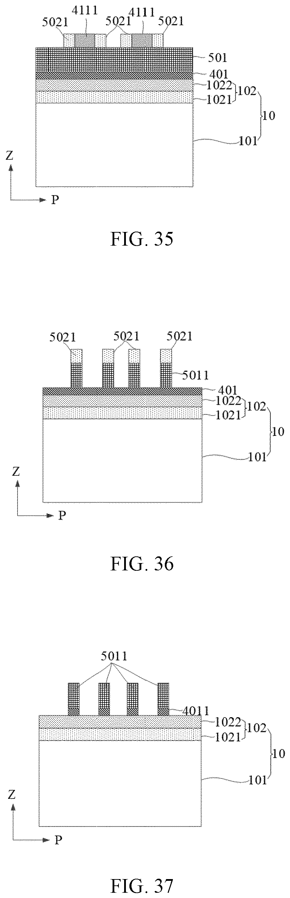

In step 16, the trimming mask layer 503 is removed, and the intermediate mask material film 502 is patterned to form an intermediate mask pattern layer. The intermediate mask pattern layer includes a plurality of intermediate mask strips 5021 disconnected from each other in the P direction. The intermediate mask strips 5021 is formed on two opposite sides of each of the sacrificial mask strips 4111, and the intermediate mask strips 5021 formed on sides close to each other of two adjacent sacrificial mask strips 4111 are disconnected from one another, i.e., two intermediate mask strips 5021 disconnected from one another are provided between the two adjacent sacrificial mask strips 4111 and formed on the side walls of one sacrificial mask strip 4111, respectively, as shown in FIG. 35.

It should be noted that when patterning the intermediate mask material film 502, only the intermediate mask material formed on the side walls of the sacrificial mask strips 4111 is retained to form the intermediate mask strips 5021, and the intermediate mask material on the remaining positions (e.g., the side of the sacrificial mask strips 4111 away from the substrate 10 and the side of the hard mask material film 501 away from the substrate 10) are removed to make the sacrificial mask strips 4111 disconnected from each other.

In step S17, the sacrificial pattern layer is removed and the hard mask material film 501 is patterned using the intermediate mask pattern layer to form a hard mask pattern layer, as shown in FIG. 36, the hard mask pattern layer includes a plurality of hard mask strips 5011 spaced apart in the P direction, and the hard mask strips 5011 correspond to the intermediate mask strips 5021 one-in-one.

In step S18, the intermediate mask strip 5021 is removed and the second conductive material film 401 is patterned using the hard mask pattern layer to form a conductive pattern layer, as shown in FIG. 37, the conductive pattern layer includes a plurality of signal lines 4011 spaced apart, the signal lines 4011 correspond to the hard mask strip 5011 one-in-one.

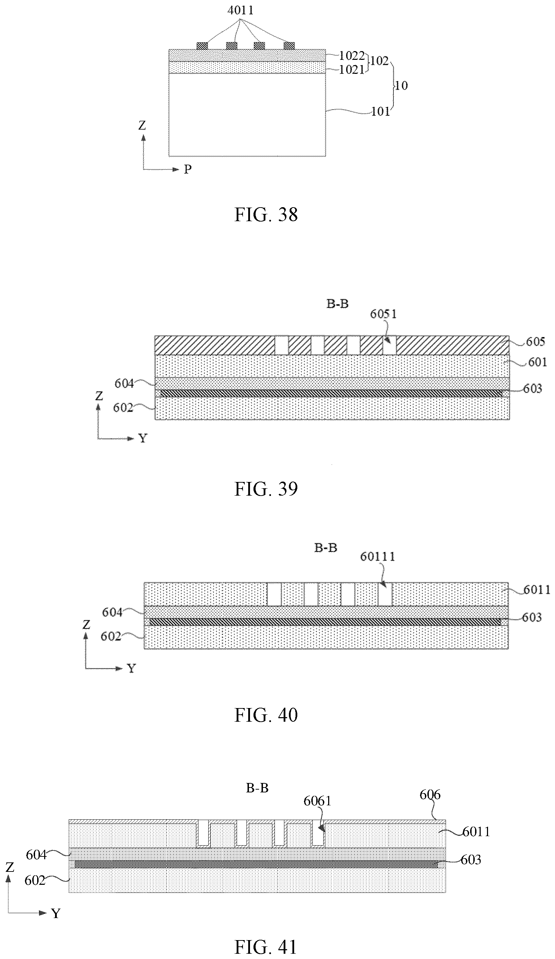

In step S19, the hard mask pattern layer is removed, as shown in FIG. 38.

It should be noted that when the signal line 4011 formed by sequentially using step S10, step S11, step S12, step S13, step S14, step S15, step S16, step S17, step S18, and step S19 is the first signal line 203 or the second signal line 205 as mentioned before, the P direction may be understood to be the second horizontal direction Y as mentioned before, and the Q direction may be understood as the first horizontal direction X as mentioned before. When the signal line 4011 formed by sequentially using step S10, step S11, step S12, step S13, step S14, step S15, step S16, step S17, step S18, and step S19 is the third signal line 204 or the fourth signal line 206 as mentioned before, the P direction can be understood as the first horizontal direction X as mentioned before, and the Q direction may be understood as the second horizontal direction Y as mentioned before.

The length of the trimming mask layer 503 in the first horizontal direction X used in the step of forming the first signal line 203 is a first length, the length of the trimming mask layer 503 in the first horizontal direction X used in the step of forming the second signal line 205 is a second length, the length of the trimming mask layer 503 in the second horizontal direction Y used in the step of forming the third signal line 204 is a third length, and the length of the trimming mask layer 503 in the second horizontal direction Y used in the step of forming the fourth signal line 206 is a fourth length.

In the same functional layer 20, when the first surface is the lead-out surface, the second length is greater than the first length, so that the extension length of the second signal line 205 is greater than the extension length of the first signal line 203, and the fourth length is greater than the third length, so that the extension length of the fourth signal line 206 is greater than the extension length of the third signal line 204; or, when the second surface is the lead-out surface, the second length is less than the first length, so that the extension length of the second signal line 205 is less than the extension length of the first signal line 203, and the fourth length is less than the third length, so that the extension length of the fourth signal line 206 is less than the extension length of the third signal line 204.

Taking the second surface as an example of the lead-out surface for specific illustration, in the step of forming the first signal line 203 and the second signal line 205, the process steps are the same except that the extension length of the trimming mask layer 503 in the Q direction in the step S14 is different, e.g., the extension length of the trimming mask layer 503 corresponding to the second signal line 205 in the Q direction is less than the extension length of the trimming mask layer 503 corresponding to the first signal line 203 in the Q direction, so as to make the extension length of the finally formed second signal line 205 less than that of the first signal line 203. Similarly, in the step of forming the third signal line 204 and the fourth signal line 206, the process steps are the same except that the extension length of the trimming mask layer 503 in the P direction in step S14 is different, e.g., the extension length of the trimming mask layer 503 corresponding to the fourth signal line 206 in the P direction is less than the extension length of the trimming mask layer 503 corresponding to the third signal line 204 in the P direction, to make the extension length of the finally formed fourth signal line 206 less than the extension length of the third signal line 204.

For example, the aforementioned conductive material film, the hard mask material film 501, and the second sacrificial material film 411 may be formed by a deposition process, for example, Chemical Vapor Deposition (CVD), Physical Vapor Deposition (PVD), Atomic Layer Deposition (ALD), and other deposition processes, but not limited thereto, coating processes, etc. can also be used, which is determined as actual.

For example, the material of the aforementioned conductive material film can be one or more of the titanium nitride (TiN), titanium(Ti), gold (Au), tungsten (W), molybdenum (Mo), indium tin oxide (ITO), aluminum (A1), copper (Cu), ruthenium (Ru), silver (Ag), and other conductive materials. Insulation materials can be one or more of silicon dioxide (SiO₂), aluminum oxide (Al₂O₃), hafnium dioxide (HfO₂), titanium dioxide (TiO₂), silicon nitride (SiN) and other materials.

It should be noted that when omitting the fabrication of the hard mask material film 501 in step S10, the second conductive material film 401 may be directly patterned using the intermediate mask pattern layer to form the conductive pattern layer after the sacrificial pattern layer is removed.

In a specific embodiment, the forming each of the first through-hole H1 and the second through-hole H2 may include step S20, step S21, step S22, step S23, step S24, step S25, and step S26.

In step S20, the third sacrificial material film 601 is formed on a side of the stacked structure away from the substrate 10, and the stacked structure includes a bottom insulation film layer 602, an intermediate signal line 603, and a top insulation film layer 604 sequentially stacked on the substrate 10.

By way of example, the third sacrificial material film 601 may include a plurality of film layers, such as: including a SiON film layer, a SOC film layer, a SiON film layer, stacked sequentially, but is not limited thereto, and other insulation materials may be used, and the third sacrificial material film 601 may also be a single-layer film, which will not be described in detail herein.

In step S21, a third photoresist mask pattern layer 605 is formed on a side of the third sacrificial material film 601 away from the substrate 10, and the third photoresist mask pattern layer 605 includes a plurality of third photolithographic perforations 6051 arrayed in a first horizontal direction X and a second horizontal direction Y, as shown in FIG. 39.

In step S22, the third sacrificial material film 601 is patterned using the third photoresist mask pattern layer 605 to form a third sacrificial pattern layer 6011. The third sacrificial pattern layer 6011 includes a plurality of third sacrificial perforations 60111 spaced apart, the third sacrificial perforations 60111 correspond to the third photolithographic perforations 6051 one-in-one, and the third sacrificial perforations 60111 open a surface of the top insulation film layer 604 away from the substrate 10, as shown in FIG. 40.

In step S23, the third photoresist mask pattern layer 605 is removed, and then an insulation material film 606 is formed. The insulation material film 606 covers the surface of the third sacrificial pattern layer 6011 away from the substrate 10 and is filled within the third sacrificial perforation 60111, and the portion of the insulation material film 606 located within the third sacrificial perforation 60111 is a blind groove structure 6061 as shown in FIG. 41.

By way of example, this insulation material film 606 may be silicon oxide, but is not limited thereto, and may be other insulation materials. This insulation material may be formed by, but is not limited to, an ALD deposition process, or by a CVD or other deposition process.

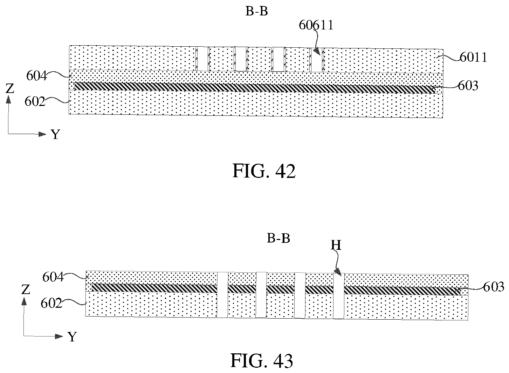

In step S24, the portion of the insulation material film 606 higher than the third sacrificial pattern layer 6011 and the bottom wall of the blind groove structure 6061 are removed, and the side walls of the blind groove structure 6061 are retained to form the target etch hole 60611, as shown in FIG. 42. The aperture diameter of the target etch hole 60611 is less than the aperture diameter of the third sacrificial perforation 60111.

In step S25, the stacked structure is patterned using the target etch hole 60611 to form the through-hole H, which passes through the stacked structure, as shown in FIG. 43.

In step S26, the third sacrificial pattern layer 6011 and the side walls of the blind groove structure 6061 on the stacked structure are removed, as shown in FIG. 43.

In the step where the through-hole H formed is a first through-hole H1, the bottom insulation film layer 602 is a first insulation film layer 209, the intermediate signal line 603 is a third signal line 204, and the top insulation film layer 604 is a second insulation film layer 210. In the step where the through-hole H formed is a second through-hole H2, the bottom insulation film layer 602 is an interlayer insulation film layer 211, the intermediate signal line 603 is a second signal line 205 or fourth signal line 206, and the top insulation film layer 604 is the third insulation film layer 212.

It should be noted that the material of the interlayer insulation film layer mentioned in this embodiment may be one or more of silicon dioxide (SiO₂), aluminum oxide (Al₂O₃), hafnium dioxide (HfO₂), titanium dioxide (TiO₂), silicon nitride (SiN), etc.

In an embodiment, the forming the first transistor structure 201 and the second transistor structure 202 includes:
forming a channel film. The channel film covers a surface of the stacked structure away from the substrate 10 and is filled in a through-hole of the stacked structure;
patterning the channel film to form a channel portion SD located within the through-hole. The channel portion SD is in the shape of a groove, and a surface of the groove side wall in the channel portion SD away from the substrate 10 is lower than a surface of the stacked structure away from the substrate;
sequentially forming a gate insulation film and a gate film. The gate insulation film and the gate film cover a surface of the stacked structure away from the substrate 10, a surface of the groove side wall of the channel portion SD away from the substrate 10, and are filled in a groove in the channel portion SD, the portion of the gate insulation film located in the through-hole is a gate insulation portion GI. A portion of the gate insulation portion GI is located in the groove in the channel portion SD, a portion of the gate insulation portion GI covers the surface of a groove side wall of the channel portion SD away from the substrate 10. The portion of the gate insulation portion GI located within the groove of the channel portion SD is in the shape of a groove, the portion of the gate film located within the groove of the gate insulation portion GI is the gate portion G, and the groove of the gate insulation portion GI is filled with the gate portion G;
removing the portion of the gate insulation film and the gate film higher than the stacked structure, such that the surfaces of the stacked structure, the gate insulation portion GI, and the gate portion G away from the substrate 10 are opened and flush with each other to form the transistor located within the through-hole.

In the forming the first transistor structure 201, the stacked structure includes a first insulation film layer 209, a third signal line layer, and a second insulation film layer 210 stacked sequentially, and the through-hole is a first through-hole H1. In the step of forming the second transistor structure 202, the stacked structure includes an interlayer insulation film layer 211, a second signal line layer, and a third insulation film layer 212 stacked sequentially, and the through-hole is a second through-hole H2.

By way of example, the channel film and the gate film may be one of Indium Gallium Zinc Oxide (IGZO), Indium Zinc Oxide (IZO), Indium Tin Oxide (ITO), which is conducive to lowering the leakage current of the transistor structure and the power consumption of the transistor structure, but is not limited thereto, and may be other semiconductor materials such as silicon. The material of the gate insulation film may be one or more of silicon dioxide (SiO₂), aluminum oxide (Al₂O₃), hafnium dioxide (HfO₂), titanium dioxide (TiO₂), silicon nitride (SiN), etc.

In this embodiment, the forming at least one functional layer 20 on the substrate 10 may specifically include sequentially forming a plurality of functional layers 20 on the substrate 10, as shown in FIGS. 1 to 3.

As shown in FIGS. 2 and 3, in two adjacent functional layers 20, the functional layer 20 away from the substrate 10 is defined as the upper functional layer, and the functional layer 20 close to the substrate 10 is defined as the lower functional layer. When the second surface is the lead-out surface, the length of the trimming mask layer 503 in the first horizontal direction X used in the step of forming the first signal line 203 in the upper functional layer is less than the length of the trimming mask layer 503 in the first horizontal direction X used in the step of forming the second signal line 205 in the lower functional layer, so that the extension length of the first signal line 203 in the upper functional layer is less than the extension length of the second signal line 205 in the lower functional layer. The length of the trimming mask layer 503 in the second horizontal direction Y used in the step of forming the third signal line 204 in the upper functional layer is less than the length of the trimming mask layer 503 in the second horizontal direction Y used in the step of forming the fourth signal line 206 in the lower functional layer, so that the extension length of the third signal line 204 in the upper functional layer is less than the extension length of the fourth signal line 206 in the lower functional layer.

However, it is not limited thereto, when the first surface is the lead-out surface, the length of the trimming mask layer 503 in the first horizontal direction X used in the step of forming the first signal line 203 in the upper functional layer is greater than the length of the trimming mask layer 503 in the first horizontal direction X used in the step of forming the second signal line 205 in the lower functional layer, so that the extension length of the first signal line 203 in the upper functional layer is greater than the extension length of the second signal line 205 in the lower functional layer. The length of the trimming mask layer 503 in the second horizontal direction Y used in the step of forming the third signal line 204 in the upper functional layer is greater than the length of the trimming mask layer 503 in the second horizontal direction Y used in the step of forming the fourth signal line 206 in the lower functional layer, so that the extension length of the third signal line 204 in the upper functional layer is greater than the extension length of the fourth signal line 206 in the lower functional layer.

It should be noted that after first forming one functional layer 20 on the substrate 10 and before stacking another functional layer 20, an insulating isolation layer 102 may be formed on the surface of the lower functional layer (the functional layer 20 close to the substrate 10) away from the substrate 10, and then the upper functional layer (the functional layer 20 away from the substrate 10) is fabricated to form a galvanic isolation between the lower functional layer and the upper functional layer 20.

In this embodiment, after the forming the at least one functional layer 20 on the substrate 10, the manufacturing method further includes:
forming a first lead-out structure S1, a third lead-out structure S2, a second lead-out structure S3, and a fourth lead-out structure S4 extending in the vertical direction Z and spaced apart from each other. Each functional layer 20 has a first lead-out structure S1, a third lead-out structure S2, a second lead-out structure S3, and a fourth lead-out structure S4, as shown in FIGS. 2 and 3.

For example, taking the second surface as the lead-out surface, the first lead-out structure S1 passes through at least the fourth insulation film layer 208, the third insulation film layer 212, the interlayer insulation film layer 211, the second insulation film layer 210, and the first insulation film layer 209 of the corresponding functional layer 20 to contact the lead-out surface of the lead-out end of the first signal line 203 in the corresponding functional layer 20. The third lead-out structure S2 passes through at least the fourth insulation film layer 208, the third insulation film layer 212, the interlayer insulation film layer 211, and the second insulation film layer 210 of the corresponding functional layer 20 to contact the lead-out surface of the lead-out end of the third signal line 204 in the corresponding functional layer 20. The second lead-out structure S3 passes through at least the fourth insulation film layer 208 and the third insulation film layer 212 of the corresponding functional layer 20 to contact the lead-out surface of the lead-out end of the second signal line 205 in the corresponding functional layer 20. The fourth lead-out structure S4 passes through at least the fourth insulation film layer 208 of the corresponding functional layer 20 to contact the lead-out surface of the lead-out end of the fourth signal line 206 in the corresponding functional layer 20.

For example, the material of the first lead-out structure S1, the third lead-out structure S2, the second lead-out structure S3, and the fourth lead-out structure S4 may be one or more of a conductive material such as titanium nitride (TiN), titanium (Ti), gold (Au), tungsten (W), molybdenum (Mo), indium tin oxide (ITO), aluminum (Al), copper (Cu), ruthenium (Ru), silver (Ag), etc.

## Claims

1. A semiconductor device, **characterized by** comprising a substrate (10) and at least one functional layer (20), wherein the functional layer (20) comprises:
a first signal line layer and a second signal line layer, stacked on the substrate (10) in a vertical direction, wherein the first signal line layer comprises a plurality of first signal lines (203) spaced apart, and the second signal line layer comprises a plurality of second signal lines (205) spaced apart, the second signal line layer is located by a side of the first signal line layer away from the substrate (10) and insulated from the second signal line layer by an insulation film layer, and the first signal line (203) and the second signal line (205) each extends in a first horizontal direction;
wherein the first signal line (203) and the second signal line (205) each has a body extension portion and a lead-out end, and for each of the first signal line (203) and the second signal line (205), the lead-out end is located at least one end of the body extension portion in the first horizontal direction;
wherein an orthographic projection of the body extension portion of the first signal line (203) overlaps with an orthographic projection of the body extension portion of the second signal line (205) on the substrate (10); and
wherein orthographic projections of the lead-out ends of the first signal line (203) and the second signal line (205) on the substrate (10) are non-overlapping.

2. The semiconductor device according to claim 1, wherein for each of the first signal line (203) and the second signal line (205), the lead-out end has a first surface close to the substrate (10) and a second surface away from the substrate (10); and
wherein for each of the first signal line (203) and the second signal line (205), a direction of the first surface pointing to the second surface or a direction of the second surface pointing to the first surface is a lead-out direction;
when the direction of the second surface pointing to the first surface is the lead-out direction, an extension length of the first signal line (203) is less than an extension length of the second signal line (205) in the same functional layer (20); or
when the direction of the first surface pointing to the second surface is the lead-out direction, the extension length of the second signal line (205) is less than the extension length of the first signal line (203) in the same functional layer (20).

3. The semiconductor device according to claim 1, wherein the functional layer (20) further comprises:
a third signal line layer with a plurality of third signal lines (204) spaced apart extending in a second horizontal direction, wherein the third signal line layer is stacked with the first signal line layer and the second signal line layer in the vertical direction, and is insulated from adjacent signal line layers of the third signal line layer by insulation film layers, and the second horizontal direction is intersected with the first horizontal direction;
wherein each third signal line (204) has a body extension portion and a lead-out end, wherein the lead-out end of the third signal line (204) is located at at least one end of the body extension portion of the third signal line (204) in the second horizontal direction.

4. The semiconductor device according to claim 3, wherein the functional layer (20) further comprises:
a fourth signal line layer with a plurality of four signal lines (206) spaced apart extending in the second horizontal direction, wherein the fourth signal line layer is stacked with the first signal line layer, the second signal line layer and the third signal line layer in the vertical direction, and is insulated from adjacent signal lines of the fourth signal line layer by insulation film layers,
wherein each fourth signal line (206) has a body extension portion and a lead-out end, wherein the lead-out end of the fourth signal line (206) is located at at least one end of the body extension portion of the fourth signal line (206) in the second horizontal direction;
wherein orthographic projection of the body extension portion of the fourth signal line (206) overlaps with orthographic projection of the body extension portion of the third signal line (204) on the substrate (10); and
wherein orthographic projections of the lead-out ends of the fourth signal line (206) and the third signal line (204) on the substrate (10) are non-overlapping.

5. The semiconductor device according to claim 4, wherein in the functional layer (20), the third signal line layer is formed between the first signal line layer and the second signal line layer,
wherein in the functional layer (20), the fourth signal line layer is formed between the third signal line layer and the second signal line layer; or
wherein in the functional layer (20), the fourth signal line layer is formed by a side of the second signal line layer away from the third signal line layer.

6. The semiconductor device according to claim 5, wherein each of the lead-out ends of the third signal line (204) and the fourth signal line (206) has a first surface close to the substrate (10) and a second surface away from the substrate (10);
wherein for each of the third signal line (204) and the fourth signal line (206), a direction of the first surface pointing to the second surface or a direction of the second surface pointing to the first surface is the lead-out direction;
when the direction of the second surface pointing to the first surface is the lead-out direction, an extension length of the third signal line (204) is less than an extension length of the fourth signal line (206) in the same functional layer (20); or
when the direction of the first surface pointing to the second surface is the lead-out direction, an extension length of the fourth signal line (206) is less than an extension length of the third signal line (204) in the same functional layer (20).

7. The semiconductor device according to claim 6, further comprising a first lead-out structure (S1), a second lead-out structure (S3), a third lead-out structure (S2) and a fourth lead-out structure (S4) spaced apart from each other, wherein the first lead-out structure (S1), the second lead-out structure (S3), the third lead-out structure (S2) and the fourth lead-out structure (S4) extend in the vertical direction and have different extension lengths;
wherein one end of the first lead-out structure (S1) is in contact with the lead-out end of the first signal line (203), and another end of the first lead-out structure (S1) extends in the lead-out direction and passes through each insulation film layer;
wherein one end of the second lead-out structure (S3) is in contact with the lead-out end of the second signal line (205), and another end of the second lead-out structure (S3) extends in the lead-out direction and passes through each insulation film layer;
wherein one end of the third lead-out structure (S2) is in contact with the lead-out end of the third signal line (204), and another end of the third lead-out structure (S2) extends in the lead-out direction and passes through each insulation film layer;
wherein one end of the fourth lead-out structure (S4) is in contact with the lead-out end of the fourth signal line (206), and another end of the fourth lead-out structure (S4) extends in the lead-out direction and passes through each insulation film layer; and
wherein each functional layer (20) has the first lead-out structure (S1), the second lead-out structure (S3), the third lead-out structure (S2) and the fourth lead-out structure (S4).

8. The semiconductor device according to claim 6, wherein a plurality of the functional layers (20) are sequentially stacked on the substrate (10) in the vertical direction;
wherein in two adjacent functional layers (20), when the direction of the second surface pointing to the first surface is the lead-out direction, an extension length of the first signal line (203) in the functional layer (20) away from the substrate (10) is greater than an extension length of the second signal line (205) in the functional layer (20) close to the substrate (10), and a length of the third signal line (204) in the functional layer (20) away from the substrate (10) is greater than a length of the fourth signal line (206) in the functional layer (20) close to the substrate (10); or
when the direction of the first surface pointing to the second surface is the lead-out direction, the extension length of the first signal line (203) in the functional layer (20) away from the substrate (10) is less than the extension length of the second signal line (205) in the functional layer (20) close to the substrate (10), and the length of the third signal line (204) in the functional layer (20) away from the substrate (10) is less than the length of the fourth signal line (206) in the functional layer (20) close to the substrate (10).

9. The semiconductor device according to claim 6, wherein the functional layer further comprises a first transistor structure (201) and a second transistor structure (202) stacked sequentially in the vertical direction, and each of the first transistor structure (201) and the second transistor structure (202) comprises a gate region, a first connection region and a second connection region;
wherein the first connection region of the first transistor structure (201) is connected to the body extension portion of the first signal line (203), the second connection region of the first transistor structure (201) is connected to the body extension portion of the third signal line (204), the first connection region of the second transistor structure (202) is connected to the gate region of the first transistor structure (201), the second connection region of the second transistor structure (202) is connected to the body extension portion of the second signal line (205), and the gate region of the second transistor structure (201) is connected to the body extension portion of the fourth signal line (206).

10. A method of manufacturing a semiconductor device, **characterized by** comprising:
(Sl), providing a substrate (10); and
(S2), forming at least one functional layer (20) on the substrate (10), wherein each the forming the functional layer (20) comprises:
(S3), forming a first signal line layer and a first insulation film layer (209) covering the first signal line layer on the substrate (10), wherein the first signal line layer comprises a plurality of first signal lines (203) spaced apart, each first signal line (203) extends in a first horizontal direction; and
(S4), forming a second signal line layer extending in the first horizontal direction by a side of the first insulation film layer (209) away from the substrate (10), wherein the second signal line layer comprises a plurality of second signal lines (205) spaced apart;
wherein the first signal line (203) and the second signal line (205) each has a body extension portion and a lead-out end, and for each of the first signal line (203) and the second signal line (205), the lead-out end is located at at least one end of the body extension portion of the first horizontal direction;
wherein an orthographic projection of the body extension portion of the first signal line (203) overlaps with an orthographic projection of the body extension portion of the second signal line (205) on the substrate (10); and
wherein orthographic projections of the lead-out ends of the first signal line (203) and the second signal line (205) on the substrate (10) are non-overlapping.

11. The method according to claim 10, wherein the (S2) forming the functional layer (20) further comprises:
before forming the second signal line layer, sequentially forming a third signal line layer with a plurality of third signal lines (204) spaced apart, a second insulation film layer (210), a fourth signal line layer with a plurality of fourth signal lines (206) spaced apart and a third insulation film layer (212) on a side of the first insulation film layer (209) away from the substrate (10), wherein the third signal line (204) and the fourth signal line (206) each extends in a second horizontal direction, the third signal line layer and the fourth signal line layer are insulated from each other by the second insulation film layer (210), the fourth signal line layer and the second signal line layer are insulated from each other by the third insulation film layer (212); or
before forming the second signal line layer, sequentially forming a third signal line layer with a plurality of third signal lines (204) spaced apart and a second insulation film layer (210) on the side of the first insulation film layer (209) away from the substrate (10), and after forming the second signal line (205), sequentially forming the third insulation film layer (212) and a fourth signal line layer with a plurality of fourth signal lines (206) spaced apart, wherein the third signal line (204) and the fourth signal line (206) each extends in the second horizontal direction, the third signal line layer and the second signal line layer are insulated from each other by the second insulation film layer (210), the second signal line layer and the fourth signal line layer are insulated from each other by the third insulation film layer (212);
wherein the third signal line (204) and the fourth signal line (206) each has a body extension portion and a lead-out end, and for each of the third signal line (204) and the fourth signal line (206), the lead-out end is located at at least one end of the body extension portion in the second horizontal direction;
wherein an orthographic projection of the body extension portion of the third signal line (204) overlaps with an orthographic projection of the body extension portion of the fourth signal line (206) on the substrate (10); and
wherein orthographic projections of the lead-out ends of the third signal line (204) and the fourth signal line (206) on the substrate (10) are non-overlapping.

12. The method according to claim 11, wherein for each of the first signal line (203), the second signal line (205), the third signal line (204) and the fourth signal line (206), the lead-out end has a first surface close to the substrate (10) and a second surface away from the substrate (10), wherein a direction of the first surface pointing to the second surface or a direction of the second surface pointing to the first surface is the lead-out direction.

13. The method according to claim 11, wherein the forming each of the first signal line (203), the second signal line (205), the third signal line (204) and the fourth signal line (206) comprise:
sequentially forming a conductive material film (401), a sacrificial material film (411) and a photoresist mask pattern layer stacked on the substrate (10), wherein the photoresist mask pattern layer comprises a plurality of photoresist mask strips (421) spaced apart;
patterning the sacrificial material film (411) using the photoresist mask pattern layer to form a sacrificial pattern layer, wherein the sacrificial pattern layer comprises a plurality of sacrificial mask strips (4111) spaced apart, and the sacrificial mask strips (4111) correspond to the photoresist mask strips (421) one-in-one;
removing the photoresist mask pattern layer, and then forming an intermediate mask material film (502) covering each sacrificial mask strip (4111);
forming a trimming mask layer (503) on a side of the intermediate mask material film (502) away from the substrate (10), wherein at least one edge region of the sacrificial mask strip (4111) in an extension direction of the sacrificial mask strip (4111) is uncovered by the trimming mask layer (503);
removing a portion of the intermediate mask material film (502) uncovered by the trimming mask layer (503);
removing the trimming mask layer (503), and then patterning the intermediate mask material film (502) to form an intermediate mask pattern layer, wherein the intermediate mask pattern layer comprises a plurality of intermediate mask strips (5021) disconnected from each other, the intermediate mask strips (5021) are formed on two opposite sides of each sacrificial mask strip (4111), and intermediate mask strips (5021) formed on sides close to each other of two adjacent sacrificial mask strips (4111) are disconnected from each other;
removing the sacrificial pattern layer, and patterning the conductive material film (401) using the intermediate mask pattern layer to form a conductive pattern layer, wherein the conductive pattern layer comprises a plurality of signal lines (4011) spaced apart, the signal lines (4011) correspond to the intermediate mask strips (5021) one-in-one; and
removing the intermediate mask pattern layer.

14. The method according to claim 13, wherein the trimming mask layer (503) used in the forming the first signal line (203) has a first length in the first horizontal direction, the trimming mask layer (503) used in the forming the second signal line (205) has a second length in the first horizontal direction, the trimming mask layer (503) used in the forming the third signal line (204) has a third length in the second horizontal direction, and the trimming mask layer (503) used in the forming the fourth signal line (206) has a fourth length in the second horizontal direction;
wherein in a same functional layer (20),
when the first surface is the lead-out surface, the second length is greater than the first length, so that an extension length of the second signal line (205) is greater than an extension length of the first signal line (203), and the fourth length is greater than the third length, so that an extension length of the fourth signal line (206) is greater than an extension length of the third signal line (204); or
when the second surface is the lead-out surface, the second length is less than the first length, so that the extension length of the second signal line (205) is less than the extension length of the first signal line (203), the fourth length is less than the third length, so that the extension length of the fourth signal line (206) is less than the extension length of the third signal line (204).

15. The method according to claim 13, wherein the forming at least one functional layer (20) on the substrate (10) comprises:
sequentially forming a plurality of functional layers (20) stacked on the substrate (10), wherein in two adjacent functional layers (20), the functional layer (20) away from the substrate (10) is defined as an upper functional layer and the functional layer (20) close to the substrate (10) is defined as a lower functional layer;
wherein when the first surface is the lead-out surface, the length of the trimming mask layer (503) in the first horizontal direction used in the forming the first signal line (203) in the upper functional layer is greater than the length of the trimming mask layer (503) in the first horizontal direction used in the forming the second signal line (205) in the lower functional layer, so that an extension length of the first signal line (203) in the upper functional layer is greater than an extension length of the second signal line (205) in the lower functional layer; and
the length of the trimming mask layer (503) in the second horizontal direction used in the forming the third signal line (204) in the upper functional layer is greater than the length of the trimming mask layer (503) in the second horizontal direction used in the forming the fourth signal line (206) in the lower functional layer, so that the extension length of the third signal line (204) in the upper functional layer is greater than the extension length of the fourth signal line (206) in the lower functional layer; or
when the second surface is the lead-out surface, the length of the trimming mask layer (503) in the first horizontal direction used in the forming the first signal line (203) in the upper functional layer is less than the length of the trimming mask layer (503) in the first horizontal direction used in the forming the second signal line (205) in the lower functional layer, so that the extension length of the first signal line (203) in the upper functional layer is less than the extension length of the second signal line (205) in the lower functional layer; and
wherein the length of the trimming mask layer (503) in the second horizontal direction used in the forming the third signal line (204) in the upper functional layer is smaller than the length of trimming mask layer (503) in the second horizontal direction used in the forming the fourth signal line (206) in the lower functional layer, so that the extension length of the third signal line (204) in the upper functional layer is smaller than the extension length of the fourth signal line (206) in the lower functional layer.
